# EUROPEAN PATENT APPLICATION

(11) **EP 3 416 195 A2**
(43) Date of publication of application: **19.12.2018**
(21) Application number: 18159245.2
(22) Date of filing: 28.02.2018
(51) Int. Cl.: H01L 29/66, H01L 29/792, H01L 27/115, H01L 27/11568

(54) **SEMICONDUCTOR DEVICE AND METHOD OF MANUFACTURING THE SEMICONDUCTOR DEVICE**

(30) Priority: 25.04.2017 JP 2017086339
(71) Applicant: Renesas Electronics Corporation, 135-0061 Tokyo (JP)
(72) Inventor: ABE, Shinichiro, Koutou-ku,, Tokyo 135-0061 (JP)
(74) Representative: Moore, Graeme Patrick

(57) **Abstract**

An insulating film configuring an uppermost layer of a gate insulating film of a memory cell comprises a silicon oxide film and is a layer to which a metal or metal oxide is added. A formation step of the insulating film comprises the steps of: forming the silicon oxide film; and adding the metal or the metal oxide in an atomic or molecular state by a sputtering process onto the silicon oxide film. Oxide of the metal has a higher dielectric constant than silicon oxide, and the metal oxide has a higher dielectric constant than silicon oxide. A High-K added layer is thus used as the insulating film configuring the gate insulating film of the memory cell, thereby a high saturation level of a threshold voltage can be maintained while a drive voltage (applied voltage for erase or write) is reduced, leading to improvement in reliability of the memory cell.

## Description

### CROSS-REFERENCE TO RELATED APPLICATIONS

The disclosure of Japanese Patent Application No. 2017-086339 filed on April 25, 2017 including the specification, drawings and abstract is incorporated herein by reference in its entirety.

### BACKGROUND

The present invention relates to a semiconductor device and a method of manufacturing the semiconductor device. For example, the invention is preferably applied to a semiconductor device comprising a nonvolatile memory.

The electrically erasable and programmable read only memory (EEPROM) is widely used as an electrically writable and erasable, nonvolatile semiconductor memory device. Such memory devices typified by a currently widely used flash memory each have a trapping insulating film surrounded by an oxide film below a gate electrode of a MISFET, in which a charge storage state in the trapping insulating film is used as memory information, and is read as a threshold of the transistor.

For example, Japanese Unexamined Patent Application Publication No. 2016-072470 discloses a nonvolatile memory having a stacked film of an insulating film, a charge storage part, and an insulating film as the trapping insulating film. The charge storage part comprises a stacked film of a silicon nitride film, a silicon oxide film formed using a treatment liquid containing water, and a silicon nitride film.

### SUMMARY

The inventors are engaged in research and development of a semiconductor device comprising a nonvolatile memory, and have made earnest investigations on improvement in characteristics of the semiconductor device. Specifically, while the trapping insulating film configuring the nonvolatile memory is an important component affecting operation characteristics of the nonvolatile memory, it has been found that a trade-off relationship exists between a reduction in write/erase voltage of the nonvolatile memory and reliability. It is therefore desired to investigate a technique that improves reliability while reducing the write/erase voltage of the nonvolatile memory.

Other objects and novel features will be clarified from the description of this specification and the accompanying drawings.

According to one embodiment, a semiconductor device comprises a first insulating film for a gate insulating film of a memory cell, the first insulating film comprising a first film having a silicon oxide film formed on a semiconductor substrate, a second film comprising a silicon nitride film formed on the first film and serving as a charge storage part, and a third film comprising a silicon oxide film formed on the second film. The third film comprises the silicon oxide film and a metal or a metal oxide added in an atomic or molecular state onto the silicon oxide film. The oxide of the metal has a dielectric constant higher than that of silicon oxide, and the metal oxide has a dielectric constant higher than that of silicon oxide.

According to one embodiment, a method of manufacturing a semiconductor device comprises a formation step of a first insulating film for a gate insulating film of a memory cell. The formation step comprises the steps of (b1) forming a first film comprising a silicon oxide film over a semiconductor substrate, (b2) forming a second film over the first film, the second film comprising a silicon nitride film and serving as a charge storage part, and (b3) forming a third film over the second film, the third film comprising a silicon oxide film as a layer to which a metal or a metal oxide is added. The step (b3) comprises the steps of (b3-1) forming the silicon oxide film over the second film, and (b3-2) adding the metal or the metal oxide onto the silicon oxide film in an atomic or molecular state by a sputtering process. The oxide of the metal has a dielectric constant higher than that of silicon oxide, and the metal oxide has a dielectric constant higher than that of silicon oxide.

According to the above-described respective embodiments, characteristics and reliability of the semiconductor device can be improved together.

### BRIEF DESCRIPTION OF THE DRAWINGS

FIGS. 1A and 1B are each a major-part sectional view of a semiconductor device of a first embodiment;
FIG. 2 is a partial enlarged sectional view schematically illustrating a state where a minute amount of metal or metal oxide is deposited on a silicon oxide film;
FIGS. 3A to 3C are graphs illustrating variation characteristics of a threshold voltage versus bias time of respective semiconductor devices of a first comparative example, a second comparative example, and the first embodiment;
FIG. 4 is a major-part sectional view of the semiconductor device of the first embodiment during a manufacturing process of the semiconductor device;
FIG. 5 is a major-part sectional view of the semiconductor device of the first embodiment during the manufacturing process of the semiconductor device;
FIG. 6 is a major-part sectional view of the semiconductor device of the first embodiment during the manufacturing process of the semiconductor device;
FIG. 7 is a major-part sectional view of the semiconductor device of the first embodiment during the manufacturing process of the semiconductor device;
FIG. 8 is a major-part sectional view of the semiconductor device of the first embodiment during the manufacturing process of the semiconductor device;
FIG. 9 is a major-part sectional view of the semiconductor device of the first embodiment during the manufacturing process of the semiconductor device;
FIG. 10 is a major-part sectional view of the semiconductor device of the first embodiment during the manufacturing process of the semiconductor device;
FIG. 11 is a major-part sectional view of the semiconductor device of the first embodiment during the manufacturing process of the semiconductor device;
FIG. 12 is a major-part sectional view of the semiconductor device of the first embodiment during the manufacturing process of the semiconductor device;
FIG. 13 is a major-part sectional view of the semiconductor device of the first embodiment during the manufacturing process of the semiconductor device;
FIG. 14 is a major-part sectional view of the semiconductor device of the first embodiment during the manufacturing process of the semiconductor device;
FIG. 15 is a major-part sectional view of the semiconductor device of the first embodiment during the manufacturing process of the semiconductor device;
FIG. 16 is a major-part sectional view of the semiconductor device of the first embodiment during the manufacturing process of the semiconductor device;
FIG. 17 is a major-part sectional view of the semiconductor device of the first embodiment during the manufacturing process of the semiconductor device;
FIG. 18 is a major-part sectional view of the semiconductor device of the first embodiment during the manufacturing process of the semiconductor device;
FIG. 19 is a major-part sectional view of the semiconductor device of the first embodiment during the manufacturing process of the semiconductor device;
FIG. 20 is a major-part sectional view of the semiconductor device of the first embodiment during the manufacturing process of the semiconductor device;
FIG. 21 is a major-part sectional view of the semiconductor device of the first embodiment during the manufacturing process of the semiconductor device;
FIG. 22 is a major-part sectional view of the semiconductor device of the first embodiment during the manufacturing process of the semiconductor device;
FIG. 23 is a major-part sectional view of the semiconductor device of the first embodiment during the manufacturing process of the semiconductor device;
FIG. 24 is a major-part sectional view illustrating a memory region of a semiconductor device of a first application example;
FIG. 25 is a major-part sectional view of a semiconductor device of a second application example during a manufacturing process of the semiconductor device;
FIG. 26 is a major-part sectional view of the semiconductor device of the second application example during the manufacturing process of the semiconductor device;
FIG. 27 is a major-part sectional view of the semiconductor device of the second application example during the manufacturing process of the semiconductor device;
FIG. 28 is a major-part sectional view of the semiconductor device of the second application example during the manufacturing process of the semiconductor device;
FIG. 29 is a major-part sectional view of the semiconductor device of the second application example during the manufacturing process of the semiconductor device;
FIG. 30 is a major-part sectional view of the semiconductor device of the second application example during the manufacturing process of the semiconductor device;
FIG. 31 is a major-part sectional view of the semiconductor device of the second application example during the manufacturing process of the semiconductor device;
FIG. 32 is a major-part sectional view of the semiconductor device of the second application example during the manufacturing process of the semiconductor device;
FIG. 33 is a major-part sectional view of the semiconductor device of the second application example during the manufacturing process of the semiconductor device;
FIG. 34 is a major-part sectional view of a semiconductor device of a third application example during a manufacturing process of the semiconductor device;
FIG. 35 is a major-part sectional view of the semiconductor device of the third application example during the manufacturing process of the semiconductor device;
FIG. 36 is a major-part sectional view of the semiconductor device of the third application example during the manufacturing process of the semiconductor device;
FIG. 37 is a major-part sectional view of the semiconductor device of the third application example during the manufacturing process of the semiconductor device;
FIG. 38 is a major-part sectional view of the semiconductor device of the third application example during the manufacturing process of the semiconductor device;
FIG. 39 is a major-part sectional view of the semiconductor device of the third application example during the manufacturing process of the semiconductor device;
FIG. 40 is a major-part sectional view of the semiconductor device of the third application example during the manufacturing process of the semiconductor device;
FIG. 41 is a major-part sectional view of the semiconductor device of the third application example during the manufacturing process of the semiconductor device;
FIG. 42 is a major-part sectional view of the semiconductor device of the third application example during the manufacturing process of the semiconductor device;
FIG. 43 is a major-part sectional view of the semiconductor device of the third application example during the manufacturing process of the semiconductor device;
FIG. 44 is a major-part sectional view of a semiconductor device of a third embodiment during a manufacturing process of the semiconductor device;
FIG. 45 is a major-part sectional view of the semiconductor device of the third embodiment during the manufacturing process of the semiconductor device;
FIG. 46 is a major-part sectional view of the semiconductor device of the third embodiment during the manufacturing process of the semiconductor device;
FIG. 47 is a major-part sectional view of the semiconductor device of the third embodiment during the manufacturing process of the semiconductor device;
FIG. 48 is a major-part sectional view of the semiconductor device of the third embodiment during the manufacturing process of the semiconductor device;
FIG. 49 is a major-part sectional view of the semiconductor device of the third embodiment during the manufacturing process of the semiconductor device;
FIG. 50 is a major-part sectional view of the semiconductor device of the third embodiment during the manufacturing process of the semiconductor device;
FIG. 51 is a major-part sectional view of the semiconductor device of the third embodiment during the manufacturing process of the semiconductor device;
FIG. 52 is a major-part sectional view of the semiconductor device of the third embodiment during the manufacturing process of the semiconductor device;
FIG. 53 is a major-part sectional view of the semiconductor device of the third embodiment during the manufacturing process of the semiconductor device;
FIG. 54 is a major-part sectional view of the semiconductor device of the third embodiment during the manufacturing process of the semiconductor device;
FIG. 55 is a major-part sectional view of the semiconductor device of the third embodiment during the manufacturing process of the semiconductor device;
FIG. 56 is a major-part sectional view of the semiconductor device of the third embodiment during the manufacturing process of the semiconductor device;
FIG. 57 is a major-part sectional view of the semiconductor device of the third embodiment during the manufacturing process of the semiconductor device;
FIG. 58 is a major-part sectional view of the semiconductor device of the third embodiment during the manufacturing process of the semiconductor device;
FIG. 59 is a major-part sectional view of the semiconductor device of the third embodiment during the manufacturing process of the semiconductor device;
FIG. 60 is a major-part sectional view of the semiconductor device of the third embodiment during the manufacturing process of the semiconductor device;
FIG. 61 is a major-part sectional view of the semiconductor device of the third embodiment during the manufacturing process of the semiconductor device;
FIG. 62 is a major-part sectional view of the semiconductor device of the third embodiment during the manufacturing process of the semiconductor device;
FIG. 63 is a major-part sectional view of the semiconductor device of the third embodiment during the manufacturing process of the semiconductor device;
FIG. 64 is a major-part sectional view of the semiconductor device of the third embodiment during the manufacturing process of the semiconductor device;
FIG. 65 is a major-part sectional view of the semiconductor device of the third embodiment during the manufacturing process of the semiconductor device;
FIG. 66 is a major-part sectional view of the semiconductor device of the third embodiment during the manufacturing process of the semiconductor device;
FIG. 67 is a major-part sectional view of the semiconductor device of the third embodiment during the manufacturing process of the semiconductor device;
FIG. 68 is a major-part sectional view of the semiconductor device of the third embodiment during the manufacturing process of the semiconductor device;
FIG. 69 is a major-part sectional view of the semiconductor device of the third embodiment during the manufacturing process of the semiconductor device;
FIG. 70 is a major-part sectional view of the semiconductor device of the third embodiment during the manufacturing process of the semiconductor device;
FIG. 71 is a major-part sectional view of the semiconductor device of the third embodiment during the manufacturing process of the semiconductor device;
FIG. 72 is a major-part sectional view of the semiconductor device of the third embodiment during the manufacturing process of the semiconductor device;
FIG. 73 is a major-part sectional view of the semiconductor device of the third embodiment during the manufacturing process of the semiconductor device;
FIG. 74 is a major-part sectional view of the semiconductor device of the third embodiment during the manufacturing process of the semiconductor device;
FIG. 75 is a major-part sectional view of the semiconductor device of the third embodiment during the manufacturing process of the semiconductor device;
FIG. 76 is a major-part sectional view of the semiconductor device of the third embodiment during the manufacturing process of the semiconductor device;
FIG. 77 is a major-part sectional view of the semiconductor device of the third embodiment during the manufacturing process of the semiconductor device;
FIG. 78 is a major-part sectional view of the semiconductor device of the third embodiment during the manufacturing process of the semiconductor device;
FIG. 79 is a major-part sectional view of the semiconductor device of the third embodiment during the manufacturing process of the semiconductor device; and
FIG. 80 is a sectional view illustrating another configuration of an insulating film MZ.

### DETAILED DESCRIPTION

Although each of the following embodiments may be dividedly described in a plurality of sections or embodiments for convenience as necessary, they are not unrelated to one another except for the particularly defined case, and are in a relationship where one is a modification, details, supplementary explanation, or the like of part or all of another one. In each of the following embodiments, when the number of elements and the like (including the number, a numerical value, amount, and a range) is mentioned, the number is not limited to a specified number except for the particularly defined case and for the case where the number is principally clearly limited to the mentioned number. In other words, the number may be not less than or not more than the mentioned number. Furthermore, it will be appreciated that in each of the following embodiments, a constitutional element (including an element step etc.) of the embodiment is not necessarily indispensable except for the particularly defined case and for the case where the constitutional element is considered to be indispensable in principle. Similarly, in each of the following embodiments, when a shape of a constitutional element, a positional relationship, and the like are described, any configuration substantially closely related to or similar to such a shape or the like should be included except for the particularly defined case and for the case where such a configuration is considered to be not included in principle. The same holds true for each of the numerical value and the range.

Hereinafter, some embodiments will be described in detail with reference to the accompanying drawings. In all drawings for explaining the embodiments, components having the same function are designated by the same numeral, and duplicated description is omitted. In the following embodiments, the same or similar portion is not repeatedly described in principle except for a particularly required case.

Furthermore, a sectional view for explaining each embodiment may not be hatched for better viewability.

### First Embodiment

### Description of Structure

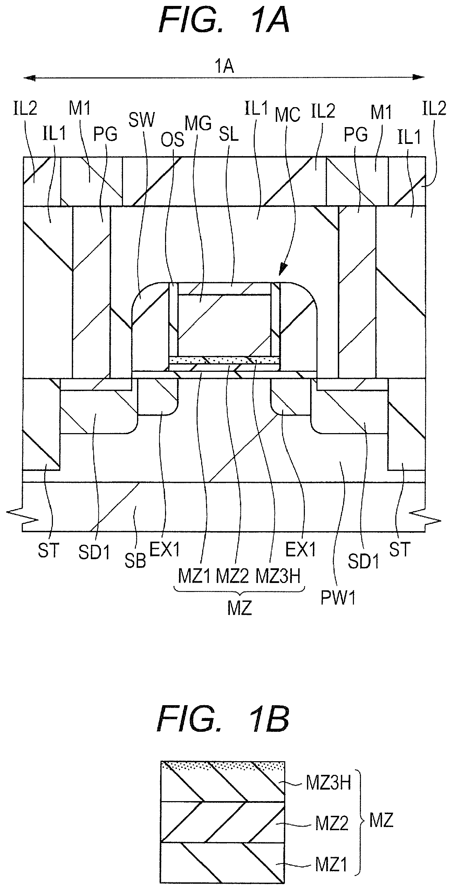

A semiconductor device of a first embodiment is described with reference to FIGS. 1A and 1B. FIGS. 1A and 1B are each a major-part sectional view of a semiconductor device of the first embodiment.

The semiconductor device of the first embodiment comprises a nonvolatile memory cell MC that is a single-gate memory cell and is formed in a memory region 1A of a semiconductor substrate SB.

Specifically, as shown in FIG. 1A, the memory cell MC comprises an insulating film MZ formed on the semiconductor substrate SB (on a p-type well PW1) in the memory region 1A, and a gate electrode (memory gate electrode) MG formed on the insulating film MZ. Specifically, the gate electrode MG is provided on the surface of the semiconductor substrate SB (p-type well PW1) with the insulating film MZ, which has a charge storage part and serves as a gate insulating film, in between. The memory cell MC further comprises an offset spacer OS and a sidewall spacer SW formed on a sidewall of the gate electrode MG, and n-type semiconductor regions (n⁻-type semiconductor region EX1 and n⁺-type semiconductor region SD1) for a source or a drain formed in the p-type well PW1 of the semiconductor substrate SB.

The insulating film MZ interposed between the semiconductor substrate SB (p-type well PW1) and the gate electrode MG serves as a gate insulating film while internally having a charge storage part. The insulating film MZ comprises a stacked film (stacked insulating film) comprising an insulating film MZ1, an insulating film MZ2 formed on the insulating film MZ1, and an insulating film MZ3H formed on the insulating film MZ2 (FIG. 1B).

In the insulating film MZ, the insulating film MZ2 has a charge storage function. Specifically, in the insulating film MZ, the insulating film MZ2 is provided to store charge, i.e., serves as a charge storage layer (charge storage part) . That is, the insulating film MZ2 is a trapping insulating film formed in the insulating film MZ. The trapping insulating film refers to a charge-storable insulating film. Hence, the insulating film MZ can be considered as an insulating film internally having a charge storage part (insulating film MZ2).

In the insulating film MZ, the insulating film MZ3H and the insulating film MZ1 located on and under the insulating film MZ2 as the trapping insulating film can each serve as a charge block layer to confirm charge in the trapping insulating film. The structure, in which the insulating film MZ2 as the trapping insulating film is sandwiched by the insulating films MZ1 and MZ3H each serving as a charge block layer, is used, making it possible to store the charge in the insulating film MZ2.

In the insulating film MZ, the insulating film MZ3H on the insulating film MZ2 and the insulating film MZ1 under the insulating film MZ2 are each necessary to have a bandgap larger than the bandgap of the charge storage layer (insulating film MZ2) between the insulating films MZ3H and MZ1. In other words, the bandgap of each of the insulating films MZ1 and MZ3H is larger than the bandgap of the insulating film MZ2 as the trapping insulating film. As a result, the insulating films MZ3H and MZ1 sandwiching the insulating film MZ2 as the charge storage layer can each serve as a charge block layer. Since the silicon oxide film has a bandgap larger than the bandgap of the silicon nitride film, a silicon nitride film can be used as a film configuring the insulating film MZ2, and the silicon oxide film can be used as a film configuring each of the insulating films MZ1 and MZ3H. A silicon oxynitride film may also be used as the film configuring the insulating film MZ1. The insulating films MZ1 to MZ3 are configured to have a silicon oxide film (film containing Si and O), a silicon nitride film (film containing Si and N), and a silicon oxide film (film containing Si and O), and thus may be referred to as oxide-nitride-oxide (ONO) film.

The memory cell MC is a field effect transistor comprising a gate insulating film (insulating film MZ) internally having a charge storage part. The memory cell MC stores or holds charge in the insulating film MZ2 of the insulating film MZ and is thus allowed to memorize information.

For example, for write operation of the memory cell MC, electrons are injected into the insulating film MZ2 of the insulating film MZ to make the memory cell MC into a write state. In this embodiment, electrons are injected into the insulating film MZ2 of the insulating film MZ from an inversion layer formed in the surface of the semiconductor substrate (p-type well PW1), thereby the memory cell MC is made into the write state. For erase operation of the memory cell MC, holes are injected into the insulating film MZ2 of the insulating film MZ to make the memory cell MC into an erase state. In this embodiment, holes are injected into the insulating film MZ2 of the insulating film MZ from the semiconductor substrate (p-type well PW1), thereby the memory cell MC is made into the erase state. In the write operation, charge (herein electrons) can be injected into the insulating film MZ2 of the insulating film MZ from the inversion layer formed in the surface of the semiconductor substrate (p-type well PW1) through Fowler Nordheim (FN) tunneling. For read operation of the memory cell MC, whether the memory cell MC is in the write state or the erase state can be determined using a fact that a threshold voltage of the memory cell MC is different between the write state and the erase state.

In the first embodiment, the insulating film MZ3H (top layer of the ONO film) comprises the silicon oxide film and a metal or a metal oxide on the silicon oxide film. The thickness (formation thickness) of the silicon oxide film is, for example, about 2 to 4 nm, and the metal or the metal oxide is a minute amount of deposit deposited in an atomic or molecular state on the silicon oxide film. An oxide film of the metal is a high dielectric film, i.e., the metal is, for example, Hf or Al. A film of the metal oxide is a high dielectric film, such as, for example, a film of HfO₂ or Al₂O₃. The high dielectric film refers to a dielectric film having a dielectric constant larger than that of silicon oxide. Hence, the insulating film MZ3H may be referred to as High-K added layer.

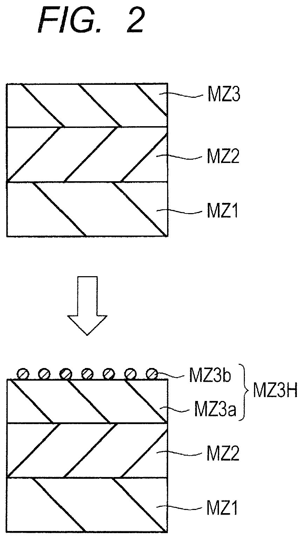

FIG. 2 is a partial enlarged sectional view schematically illustrating a state where a minute amount of metal or metal oxide MZ3b is deposited onto the silicon oxide film MZ3a.

For example, as shown in FIG. 2, the metal or metal oxide MZ3b can be deposited using a sputtering process on the insulating film MZ3 (for example, a silicon oxide film), specifically on the silicon oxide film MZ3a, of the stacked body, in which the insulating film (for example, a silicon oxide film) MZ1, the insulating film (for example, a silicon nitride film) MZ2, and the insulating film (for example, a silicon oxide film) MZ3 are sequentially stacked. In this case, the metal may exist in a form of a metal oxide formed by being bonded with oxygen in the silicon oxide film MZ3a, oxygen contained in an oxidizing atmosphere introduced during deposition in the case of deposition in an oxygen atmosphere, or oxygen contained in the air exposed after deposition. For example, hafnium (Hf), Al or both of Hf and Al can be used as the metal. In such a case, the metal oxide is comprised of HfO₂ or Al₂O₃. Zirconium (Zr), platinum (Pt), molybdenum (Mo), or tungsten (W) may be used as the metal in place of Hf or Al.

In a possible case, for example, Hf is deposited 1.0 × 10¹⁴ atoms/cm² at a low power of 27 W by a sputtering process using Hf as a target, and then Al is deposited 3.0 × 10¹³ atoms/cm² at a low power of 100 W by a sputtering process using Al as a target.

For example, the surface density of the metal MZ3b deposited on the silicon oxide film MZ3a is controlled within a range from 1 × 10¹³ to 5 × 10¹⁴ atoms/cm². The surface density of the metal or metal oxide deposited on the silicon oxide film MZ3a is preferably 1 × 10¹³ to 5 × 10¹⁴ atoms/cm² as described above, and more preferably within a range from 3 × 10¹³ to 1.5 × 10¹⁴ atoms/cm². The surface density of the metal oxide MZ3b means surface density of the metal composing the metal oxide.

Although sputtering is performed using a metal target of Hf or Al in the above specific example, the sputtering may be performed using a metal oxide target.

In this way, a minute amount of metal MZ3b comprising, for example, Hf atoms or Al atoms, is deposited on the silicon oxide film MZ3a. As schematically shown in FIG. 2, therefore, such an extremely small amount, which is insufficient for film formation, of the metal or metal oxide MZ3b (for example, Hf atoms, HfO₂ molecules, Al atoms, Al₂O₃ molecules) is exclusively deposited on the silicon oxide film MZ3a rather than a film-like deposit such as a HfO₂ film or an Al₂O₃ film (see a lower view of FIG. 2). In other words, monoatoms or monomolecules of the metal or metal oxide MZ3b are chemically adsorbed on the surface of the silicon oxide film MZ3a.

In this way, in the first embodiment, since the High-K added layer is used as the insulating film MZ3H configuring the gate insulating film of the memory cell MC, a back tunnel, through which electrons are injected from the gate electrode into the insulating film during erase operation, is suppressed while the drive voltage (applied voltage for erase or write) is reduced. This allows for a high saturation level of the threshold voltage for erase, which in turn suppresses deterioration of the insulating film due to rewrite stress, leading to improvement in reliability of the memory cell. Thus, operation characteristics can be improved while reliability of the memory cell is maintained.

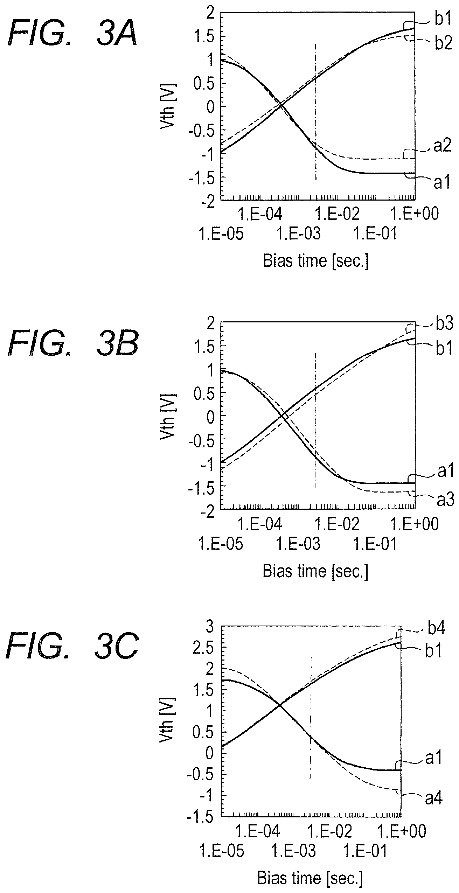

FIGS. 3A to 3C are graphs illustrating variation characteristics of a threshold voltage versus bias time of respective semiconductor devices (memory cells) of a first comparative example, a second comparative example, and the first embodiment. The abscissa represents bias time [sec], and the ordinate represents threshold voltage (Vth) [V]. FIG. 3A shows a case of a first comparative example, and FIG. 3B shows a case of a second comparative example. Each of the memory cells of the first and second comparative examples uses a typical ONO film instead of the High-K added layer. FIG. 3C shows a case of the first embodiment. The dot-and-dash line indicates a position at which bias time is 3 msec.

As shown in FIG. 3A, when the entire ONO film is assumed to comprise SiN, and when an electrical thickness (thickness calculated from a capacitance value determined by CV capacitance measurement assuming that all the layers comprise SiN (dielectric constant about 7.6), i.e., ONO film thickness) is assumed to be 19.8 nm, the threshold voltage Vth sufficiently lowers with an increase in bias time in a graph a1 for erase (applied voltage -8.6 V). When the ONO film thickness is assumed to be 18.3 nm, the threshold voltage Vth does not sufficiently lower and is saturated at a higher position in a graph a2 for erase (applied voltage -8.2 V). When the ONO film thickness is assumed to be 19.8 nm, the threshold voltage Vth sufficiently rises with an increase in bias time in a graph b1 for write (applied voltage +10.0 V). When the ONO film thickness is assumed to be 18.3 nm, the threshold voltage Vth does not sufficiently rise and is saturated at a lower position in a graph b2 for write (applied voltage +9.2 V).

In this way, when the ONO film thickness is decreased, the drive voltage (applied voltage for erase or write) can be lowered, but the saturation level of the threshold voltage is reduced. The term "saturation level of the threshold voltage" means an absolute value of the threshold voltage at a position at which a change in threshold voltage becomes gentle. Such saturation of the threshold voltage represents a state where hole injection from the semiconductor substrate is balanced with electron injection from the gate (back tunnel) . In this state, although a large amount of current flows through the ONO film, the threshold voltage does not lower. Operation in such a state causes a large rewrite stress, leading to a possibility of deterioration in the insulating film (ONO film). Such deterioration in the insulating film (ONO film) may lead to deterioration in reliability (retention characteristics after rewrite) of the memory.

In response to this, thickness of the top layer is effectively increased relative to the bottom layer of the ONO film in order to increase the saturation level of the threshold voltage. However, as shown in FIG. 3B, when the thickness of the top layer of the ONO film is increased so that the ONO film thickness is 20.4 nm, although the threshold voltage Vth sufficiently lowers in a graph a3 for erase (applied voltage -8.6 V) compared with the graph a1, the threshold voltage Vth does not sufficiently lower at a position where bias time is 3 msec, showing slow erase operation.

When the thickness of the top layer of the ONO film is increased so that the ONO film thickness is 20.4 nm, although the threshold voltage Vth sufficiently rises in a graph b3 for write (applied voltage +10.0 V), the threshold voltage Vth does not sufficiently rise at the position where bias time is 3 msec, showing slow write operation.

In this way, when the thickness of the top layer of the ONO film is increased, although the saturation level of the threshold voltage is increased, erase or write speed becomes low; hence, the drive voltage (applied voltage for erase or write) must be increased.

As described above, there is a trade-off relationship between a reduction in the drive voltage (applied voltage for erase or write) and reliability.

In contrast, in the first embodiment, as shown in FIG. 3C, when the thickness of the ONO film is 19.8 nm, the threshold voltage Vth sufficiently lowers with an increase in bias time in a graph a4 for erase (applied voltage -8.2 V), and the threshold voltage Vth sufficiently lowers even at a position where bias time is 3 msec. When the thickness of the ONO film is 19.8 nm, the threshold voltage Vth sufficiently rises with an increase in bias time in a graph b4 for write (applied voltage +9.6 V), and the threshold voltage Vth sufficiently rises even at a position where bias time is 3 msec. In this way, good characteristics are shown compared with the graphs b1 and a1. That is, a high saturation level of the threshold voltage can be maintained while the drive voltage (applied voltage for erase or write) is reduced, leading to improvement in reliability of the memory cell.

As described above, the High-K added layer is used as the insulating film (top layer of the ONO film) MZ3H configuring the gate insulating film of the memory cell MC, thereby the characteristics are improved. The reason for this is considered as follows. An increase in dielectric constant due to the High-K added layer increases an electric field applied the bottom layer of the ONO film, leading to a reduction in applied voltage for erase or write. On the other hand, the physical thickness of the ONO film slightly increases, and thus a back tunnel current component from the gate electrode MG decreases, thereby the saturation level of the threshold voltage is increased.

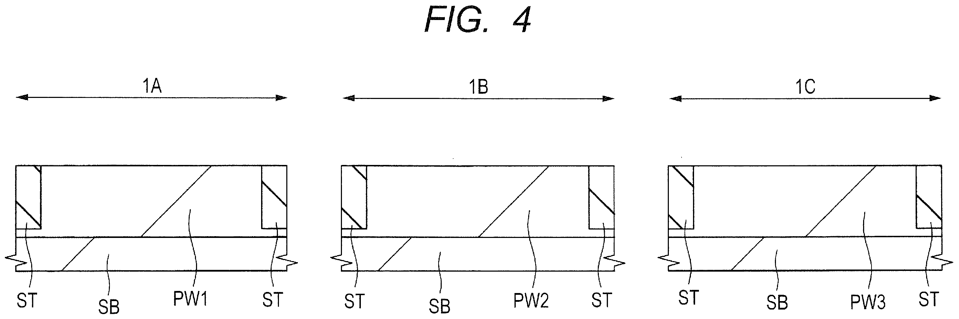

Although FIG. 1 shows the memory cell MC formed in the memory region 1A of the semiconductor substrate SB, a low-withstand-voltage MISFET2 and a high-withstand-voltage MISFET3 may be provided in the semiconductor substrate SB. A configuration and a manufacturing process of the semiconductor device comprising the memory cell MC, the low-withstand-voltage MISFET2, and the high-withstand-voltage MISFET3 are described with reference to FIGS. 4 to 23. FIGS. 4 to 23 are each a major-part sectional view of the semiconductor device of the first embodiment during the manufacturing process of the semiconductor device.

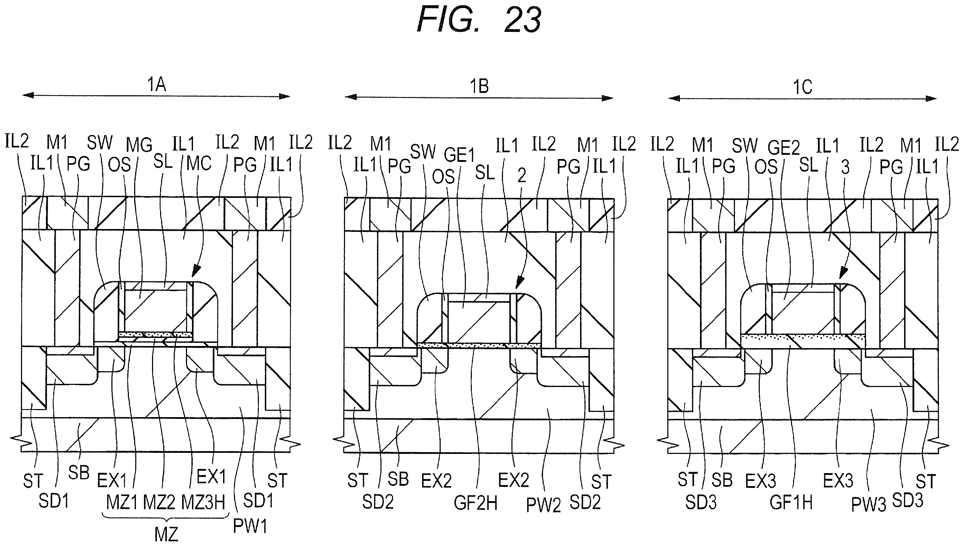

As shown in FIG. 23 illustrating the final step among the drawings illustrating the manufacturing process, the semiconductor device of the first embodiment comprises the memory cell MC, the low-withstand-voltage MISFET2 formed in a low-withstand-voltage MISFET formation region 1B of the semiconductor substrate SB, and the high-withstand-voltage MISFET3 formed in a high-withstand-voltage MISFET formation region 1C of the semiconductor substrate SB.

Specifically, the low-withstand-voltage MISFET2 comprises an insulating film GF2H formed on the semiconductor substrate SB (p-type well PW2) in the low-withstand-voltage MISFET formation region 1B, and a gate electrode GE1 formed on the insulating film GF2H. That is, the gate electrode GE1 is provided on the surface of the semiconductor substrate SB (p-type well PW2) in the low-withstand-voltage MISFET formation region 1B with the insulating film GF2H serving as a gate insulating film in between. The low-withstand-voltage MISFET2 further comprises an offset spacer OS and a sidewall spacer SW formed on a sidewall of the gate electrode GE1, and n-type semiconductor regions (n⁻-type semiconductor region EX2 and n⁺-type semiconductor region SD2) for a source or a drain formed in the p-type well PW2 of the semiconductor substrate SB.

The high-withstand-voltage MISFET3 comprises an insulating film GF1H formed on the semiconductor substrate SB (p-type well PW3) in the high-withstand-voltage MISFET formation region 1C, and a gate electrode GE2 formed on the insulating film GF1H. That is, the gate electrode GE2 is provided on the surface of the semiconductor substrate SB (p-type well PW3) in the high-withstand-voltage MISFET formation region 1C with the insulating film GF1H serving as a gate insulating film in between. The high-withstand-voltage MISFET3 further comprises an offset spacer OS and a sidewall spacer SW formed on a sidewall of the gate electrode GE2, and n-type semiconductor regions (n⁻-type semiconductor region EX3 and n⁺-type semiconductor region SD3) for a source or a drain formed in the p-type well PW3 of the semiconductor substrate SB.

The thickness of the insulating film GF1H interposed between the gate electrode GE2 and the semiconductor substrate SB (p-type well PW3) in the high-withstand-voltage MISFET formation region 1C is larger than the thickness of the insulating film GF2H interposed between the gate electrode GE1 and the semiconductor substrate SB (p-type well PW2) in the low-withstand-voltage MISFET formation region 1B. The withstand voltage of the MISFET3 is therefore higher than the withstand voltage of the MISFET2.

The insulating film GF2H serving as the gate insulating film of the low-withstand-voltage MISFET2 and the insulating film GF1H serving as the gate insulating film of the high-withstand-voltage MISFET3 are each a High-K added layer. Specifically, as with the insulating film MZ3H, the insulating films GF2H and GF1H each comprise a minute amount of deposit deposited in an atomic or molecular state on the silicon oxide film. This allows each of the low-withstand-voltage MISFET2 and the high-withstand-voltage MISFET3 to have improved characteristics (high threshold voltage and fast operation). In particular, the low-withstand-voltage MISFET2 is required to have a high threshold voltage and fast operation characteristics, and thus preferably comprises the High-K added layer.

### Description of Manufacturing Method

A method of manufacturing the semiconductor device of the first embodiment is now described with reference to FIGS. 4 to 23. FIGS. 4 to 23, which each illustrate a major-part sectional view of the memory region 1A, the low-withstand-voltage MISFET region 1B, and the high-withstand-voltage MISFET region 1C, show an aspect where a memory cell MC of a nonvolatile memory, the low-withstand-voltage MISFET2, and the high-withstand-voltage MISFET3 are formed in the memory region 1A, the low-withstand-voltage MISFET formation region 1B, and the high-withstand-voltage MISFET formation region 1C, respectively.

The memory region 1A is a region of the main surface of the semiconductor substrate SB, in which the memory cell of the nonvolatile memory is to be formed. The low-withstand-voltage MISFET formation region 1B and the high-withstand-voltage MISFET formation region 1C are each a region of the main surface of the semiconductor substrate SB, in which a peripheral circuit is to be formed.

As described above, the memory cell of the nonvolatile memory formed in the memory region 1A is a single-gate memory cell. The memory cell uses a trapping insulating film (charge-storable insulating film) for the charge storage part.

The peripheral circuit comprises circuits other than the nonvolatile memory, such as, for example, a processor such as CPU, a control circuit, a sense amplifier, a column decoder, a row decoder, and an input/output circuit. The MISFET formed in each of the low-withstand-voltage MISFET formation region 1B and the high-withstand-voltage MISFET formation region 1C is a MISFET for the peripheral circuit.

The low-withstand-voltage MISFET formation region 1B is a region, in which a low-withstand-voltage MISFET for the peripheral circuit is to be formed. The high-withstand-voltage MISFET formation region 1C is a region, in which a high-withstand-voltage MISFET for the peripheral circuit is to be formed.

The drive voltage of the high-withstand-voltage MISFET is higher than that of the low-withstand-voltage MISFET. The thickness of the gate insulating film of the high-withstand-voltage MISFET is larger than that of the low-withstand-voltage MISFET.

To manufacture the semiconductor device, as shown in FIG. 4, first, the semiconductor substrate (semiconductor wafer) SB is provided, which comprises p-type single crystal silicon having a specific resistance of about 1 to 18 Ω•cm, for example. Subsequently, a cell isolation region ST defining an active region is formed on the main surface of the semiconductor substrate SB.

The cell isolation region ST comprises an insulator such as silicon oxide, and is formed by a shallow trench isolation (STI) process or a local oxidization of silicon (LOCOS) process, for example. For example, a trench for cell isolation is formed in the main surface of the semiconductor substrate SB, and then the cell isolation trench is filled with an insulating film made of, for example, silicon oxide, and thereby the cell isolation region ST is formed.

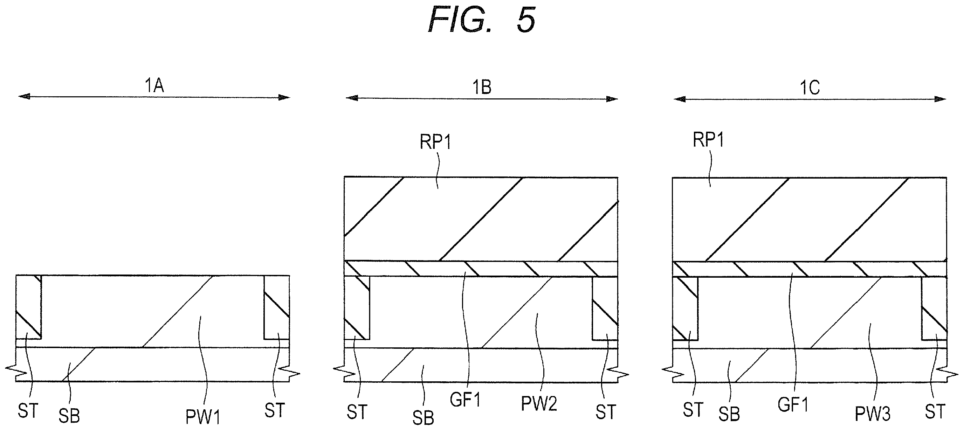

Subsequently, as shown in FIG. 5, the p-type well PW1, the p-type well PW2, and the p-type well PW3 are formed in the memory region 1A, the low-withstand-voltage MISFET formation region 1B, and the high-withstand-voltage MISFET formation region 1C, respectively, of the semiconductor substrate SB.

The p-type wells PW1, PW2, and PW3 are each formed by ion-implanting a p-type impurity such as, for example, boron (B) into the semiconductor substrate SB.

Subsequently, the surface of the semiconductor substrate SB is cleaned by wet etching using a hydrofluoric acid (HF) solution, for example, and then the insulating film GF1 is formed on the surface (comprising the surfaces of the p-type wells PW1, PW2, and PW3) of the semiconductor substrate SB.

The insulating film GF1 is an insulating film for the gate insulating film of the MISFET3 formed in the high-withstand-voltage MISFET formation region 1C. The insulating film GF1 preferably comprises a silicon oxide film, and may be formed by thermal oxidation treatment (thermal oxidation process), or may also be formed by further depositing a CVD film (silicon oxide film formed by a CVD process) on the thermally-oxidized film after the thermal oxidation process. The insulating film GF1 is formed on the semiconductor substrate SB (p-type well PW1) in the memory region 1A, on the semiconductor substrate SB (p-type well PW2) in the low-withstand-voltage MISFET formation region 1B, and on the semiconductor substrate SB (p-type well PW3) in the high-withstand-voltage MISFET formation region 1C. Although FIG. 5 shows a case where the insulating film GF1 is also formed on the cell isolation region ST, when the insulating film GF1 is formed by the thermal oxidation process, the insulating film GF1 is not formed on the cell isolation region ST. The thickness (formation thickness) of the silicon oxide film as the insulating film GF1 is preferably 5 nm or more, for example, about 7 to 8 nm.

Subsequently, a photoresist film PR1 is formed as a mask layer over the semiconductor substrate SB, i.e., on the insulating film GF1 by a photolithography technique. The photoresist film PR1 is formed in each of the low-withstand-voltage MISFET formation region 1B and the high-withstand-voltage MISFET formation region 1C, but is not formed in the memory region 1A.

Subsequently, the insulating film GF1 is etched using the photoresist film PR1 as an etching mask, thereby the insulating film GF1 is removed from the memory region 1A so that the insulating film GF1 remains in each of the low-withstand-voltage MISFET formation region 1B and the high-withstand-voltage MISFET formation region 1C. Wet etching is preferably used for such etching. For example, hydrofluoric acid is preferably used as an etchant. Subsequently, the photoresist film PR1 is removed.

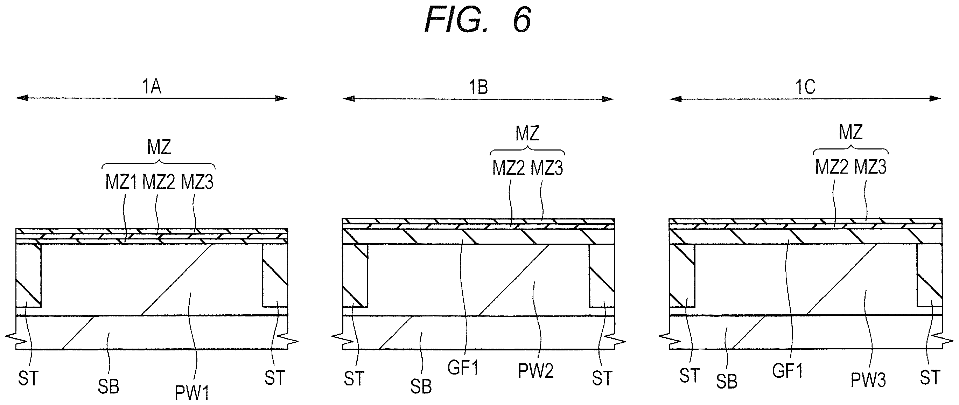

Subsequently, as shown in FIG. 6, an insulating film (stacked insulating film) MZ is formed on the main surface of the semiconductor substrate SB. At this time, in the memory region 1A, the insulating film MZ is formed on the surface (silicon surface) of the semiconductor substrate SB (p-type well PW1). In the low-withstand-voltage MISFET formation region 1B, the insulating film MZ is formed on the insulating film GF1 on the semiconductor substrate SB (p-type well PW2). In the high-withstand-voltage MISFET formation region 1C, the insulating film MZ is formed on the insulating film GF1 on the semiconductor substrate SB (p-type well PW3).

The insulating film MZ is an insulating film for the gate insulating film of the memory cell MC formed in the memory region 1A, and internally has a charge storage part (charge storage layer). The insulating film MZ comprises a stacked film of the insulating film MZ1, the insulating film MZ2 formed on the insulating film MZ1, and the insulating film MZ3 formed on the insulating film MZ2. The insulating film MZ1 preferably comprises a silicon oxide film, the insulating film MZ2 preferably comprises a silicon nitride film, and the insulating film MZ3 preferably comprises a silicon oxide film. A minute amount of deposit deposited in an atomic or molecular state is formed on the silicon oxide film of the uppermost layer by a deposition process of a metal or a metal oxide in a later step.

The insulating film MZ1 comprises a silicon oxide film, and may be formed by thermal oxidation treatment (thermal oxidation process). Rapid thermal oxidation (RTO) is more preferably used for the thermal oxidation treatment. The thickness (formation thickness) of the silicon oxide film as the insulating film MZ1 is, for example, about 1 to 3 nm.

Through the insulating film MZ1 formation step (thermal oxidation treatment to form the insulating film MZ1), the insulating film MZ1 is formed on the surface (silicon surface) of the semiconductor substrate SB (p-type well PW1) in the memory region 1A. The thickness of the insulating film GF1 increases rather than formation of the insulating film MZ1 in each of the low-withstand-voltage MISFET formation region 1B and the high-withstand-voltage MISFET formation region 1C.

Subsequently, the insulating film MZ2 is formed (insulating film MZ2 formation step). The insulating film MZ2 comprises a silicon nitride film, and may be formed using a chemical vapor deposition (CVD) process or the like. The thickness (formation thickness) of the silicon nitride film as the insulating film MZ2 is about 5 to 13 nm, for example. The silicon nitride film may be formed in one batch or in several batches.

Through the insulating film MZ2 formation step, the insulating film MZ2 is formed on the insulating film MZ1 in the memory region 1A, and the insulating film MZ2 is formed on the insulating film GF1 in each of the low-withstand-voltage MISFET formation region 1B and the high-withstand-voltage MISFET formation region 1C. The insulating film MZ2 may also be formed on the cell isolation region ST.

Subsequently, the insulating film MZ3 is formed (insulating film MZ3 formation step). The insulating film MZ3 comprises a silicon oxide film, and may be formed by a CVD process and/or a thermal oxidation process. The thickness (formation thickness) of the silicon oxide film as the insulating film MZ3 is, for example, about 2 to 4 nm.

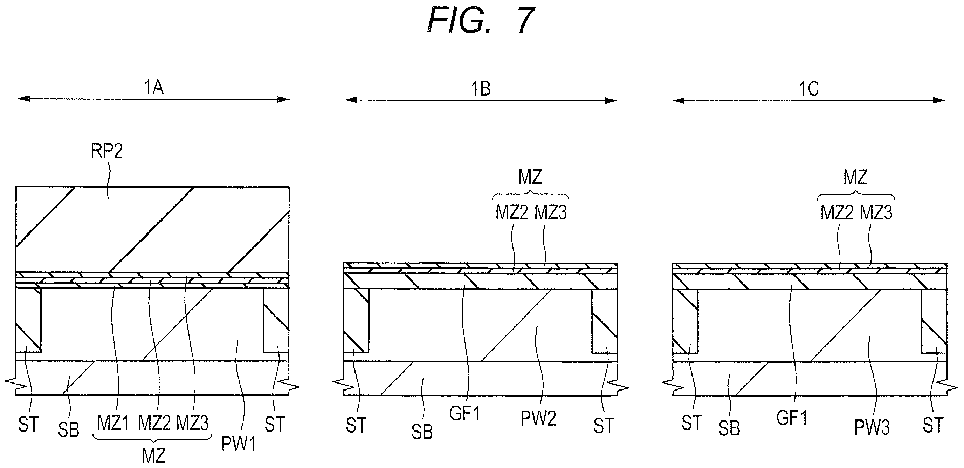

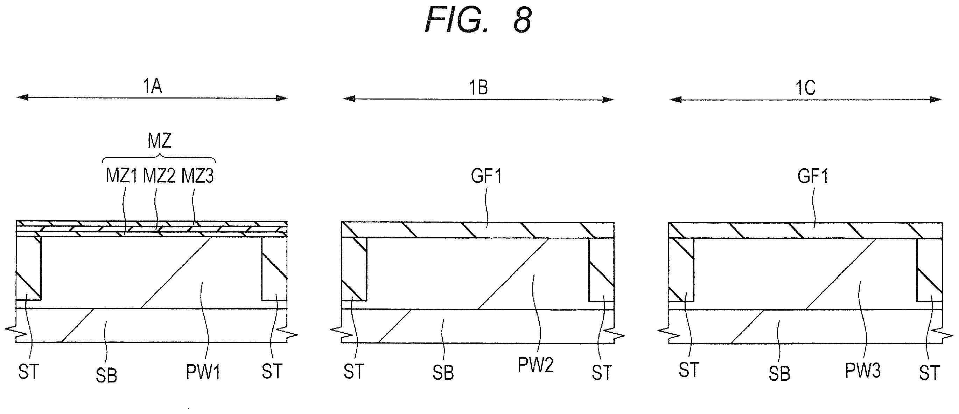

In a subsequent step, as shown in FIGS. 7 and 8, the insulating film MZ is removed by etching from each of the low-withstand-voltage MISFET formation region 1B and the high-withstand-voltage MISFET formation region 1C so that the insulating film MZ remains in the memory region 1A. Specifically, such a step is performed as follows.

That is, as shown in FIG. 7, a photoresist film PR2 is formed as a mask layer on the semiconductor substrate SB by a photolithography technique. The photoresist film PR2 is formed in the memory region 1A, but is not formed in each of the low-withstand-voltage MISFET formation region 1B and the high-withstand-voltage MISFET formation region 1C. The insulating film MZ is etched using the photoresist film PR2 as an etching mask to remove the insulating film MZ from the low-withstand-voltage MISFET formation region 1B and the high-withstand-voltage MISFET formation region 1C (FIG. 8). In a possible process, the insulating film (silicon oxide film) MZ3 is removed using hydrofluoric acid as an etchant, and then the photoresist film PR2 is removed, and the insulating film (silicon nitride film) MZ2 is further removed using a hot phosphoric acid as an etchant.

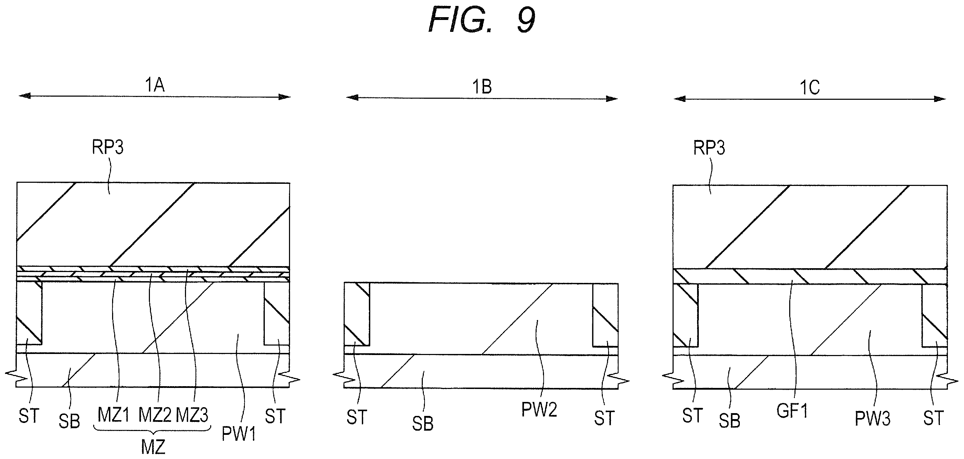

Subsequently, as shown in FIG. 9, a photoresist film PR3 is formed as a mask layer on the semiconductor substrate SB by a photolithography technique. The photoresist film PR3 is formed in the memory region 1A and in the high-withstand-voltage MISFET formation region 1C, but is not formed in the low-withstand-voltage MISFET formation region 1B. The insulating film GF1 is etched using the photoresist film PR3 as an etching mask, thereby the insulating film GF1 is removed from the low-withstand-voltage MISFET formation region 1B so that the insulating film MZ remains in the memory region 1A and the insulating film GF1 remains in the high-withstand-voltage MISFET formation region 1C. Wet etching is preferably used for such etching. For example, hydrofluoric acid is preferably used as an etchant. In the low-withstand-voltage MISFET formation region 1B, since the insulating film GF1 is removed, the surface (silicon surface) of the semiconductor substrate SB (p-type well PW2) is exposed. Subsequently, the photoresist film PR3 is removed.

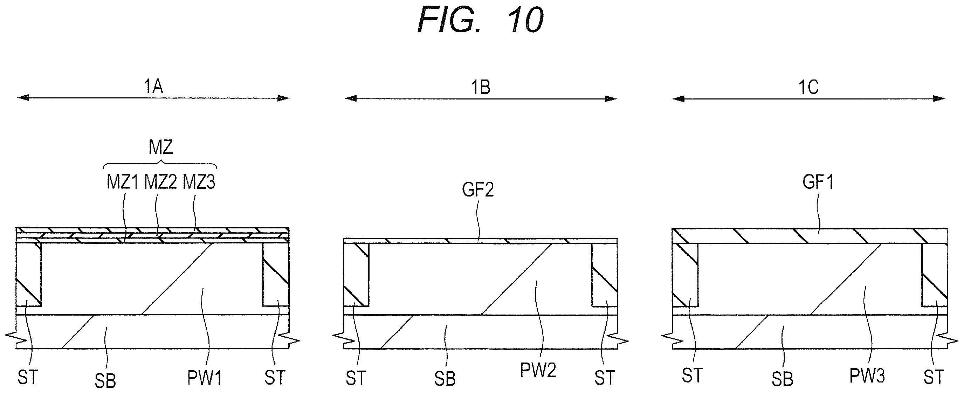

Subsequently, as shown in FIG. 10, the insulating film GF2 is formed on the surface of the semiconductor substrate SB (p-type well PW2) in the low-withstand-voltage MISFET formation region 1B.

The insulating film GF2 is an insulating film for the gate insulating film of the MISFET2 formed in the low-withstand-voltage MISFET formation region 1B. The insulating film GF2 preferably comprises a silicon oxide film, and may be formed by thermal oxidation treatment (thermal oxidation process). The formation thickness of the insulating film GF2 is smaller than the formation thickness of the insulating film GF1, and is, for example, about 1 to 4 nm. When the insulating film GF2 formation step (thermal oxidation treatment for forming the insulating film GF2) is performed, the insulating film GF2 is formed on the surface (silicon surface) of the semiconductor substrate SB (p-type well PW2) in the low-withstand-voltage MISFET formation region 1B. At a stage immediately before the insulating film GF2 formation step, the uppermost surface of the memory region 1A is the surface of the insulating film MZ3, and the uppermost surface of the high-withstand-voltage MISFET formation region 1C is the surface of the insulating film GF1. Hence, when the insulating film GF2 formation step (thermal oxidation treatment for forming the insulating film GF2) is performed, thickness of the insulating film MZ3 increases rather than formation of the insulating film GF2 in the memory region 1A, and thickness of the insulating film GF1 increases rather than formation of the insulating film GF2 in the high-withstand-voltage MISFET formation region 1C.

In this way, the structure of FIG. 10 is provided. In the structure of FIG. 10, the insulating film MZ comprising a stacked film of the insulating film MZ1, the insulating film MZ2, and the insulating film MZ3 is provided on the semiconductor substrate SB (p-type well PW1) in the memory region 1A. The insulating film GF2 is provided on the semiconductor substrate SB (p-type well PW2) in the low-withstand-voltage MISFET formation region 1B, and the insulating film GF1 is provided on the semiconductor substrate SB (p-type well PW3) in the high-withstand-voltage MISFET formation region 1C.

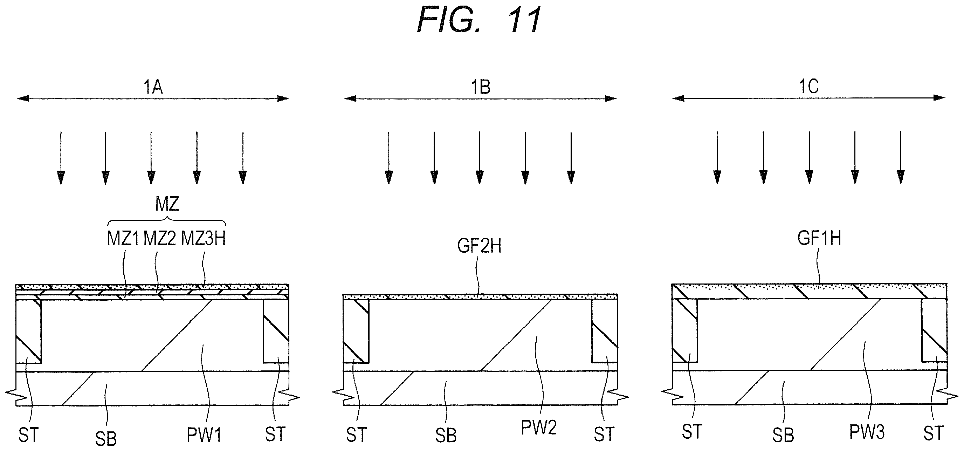

Subsequently, as shown in FIG. 11, addition (deposition processing) of a metal or a metal oxide is performed on the insulating film MZ comprising the stacked film of the insulating film MZ1, the insulating film MZ2, and the insulating film MZ3 in the memory region 1A, on the insulating film GF2 in the low-withstand-voltage MISFET formation region 1B, and on the insulating film GF1 in the high-withstand-voltage MISFET formation region 1C. In other words, a minute amount of metal atoms or metal oxide molecules are deposited on the respective insulating films (insulating films MZ3, GF2, and GF1). For example, the metal or metal oxide MZ3b is deposited on the silicon oxide film MZ3a using a sputtering process.

For example, Hf is deposited 1.0 × 10¹⁴ atoms/cm² at a low output of 27 W by a sputtering process using Hf as a target, and then Al is deposited 3.0 × 10¹³ atoms/cm² at a low output of 100 W by a sputtering process using Al as a target. Such metal atoms (Hf, Al) may be converted into metal oxides (HfO₂, Al₂O₃). Al may be first deposited before deposition of Hf. The sputtering may be performed using a metal oxide target.

For example, the surface density of the metal or metal oxide MZ3b deposited on the silicon oxide film MZ3a is preferably 1 × 10¹³ to 5 × 10¹⁴ atoms/cm² as described above, and more preferably within a range from 3 × 10¹³ to 1.5 × 10¹⁴ atoms/cm².

As described above, the metal or metal oxide (for example, Hf atoms, HfO₂ molecules, Al atoms, Al₂O₃ molecules) is deposited in an atomic or molecular state after formation of the insulating films (insulating films MZ3, GF2, and GF1) configuring the gate insulating films of the respective cells, thereby the insulating films (insulating films MZ3, GF2, and GF1) configuring the gate insulating films of the cells can be simultaneously processed.

This makes it possible to form the insulating films (insulating films MZ3H, GF2H, and GF1H) to which the metal or the metal oxide is added.

In this way, the metal or metal oxide is added to the insulating films (insulating films MZ3, GF2, and GF1) configuring the gate insulating films of the respective cells, making it possible to improve the characteristics of the low-withstand-voltage MISFET2 and the high-withstand-voltage MISFET3. For the memory cell, a high saturation level of the threshold voltage can be maintained while the drive voltage (applied voltage for erase or write) is reduced, leading to improvement in reliability of the memory cell.

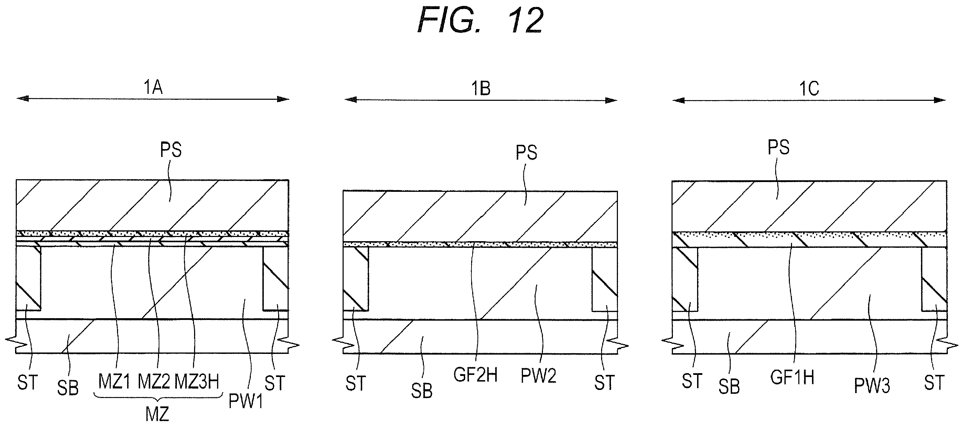

Subsequently, as shown in FIG. 12, a silicon layer PS is formed as a film (conductive film) for formation of the gate electrode on the main surface (entire main surface) of the semiconductor substrate SB. The silicon layer PS is partly a film for forming the gate electrode MG for the memory cell MC, partly a film for forming the gate electrode GE1 for the MISFET2, and partly a film for forming the gate electrode GE2 for the MISFET3.

The silicon layer PS comprises a polycrystalline silicon film, and may be formed using a CVD process or the like. The thickness of the silicon layer PS is preferably 30 to 200 nm, for example, about 100 nm. In a possible film formation, the silicon layer PS is first formed as an amorphous silicon film, and then the amorphous silicon film is converted into the polycrystalline silicon film by subsequent heat treatment. The silicon layer PS may be a doped polysilicon film doped with an n-type or p-type impurity.

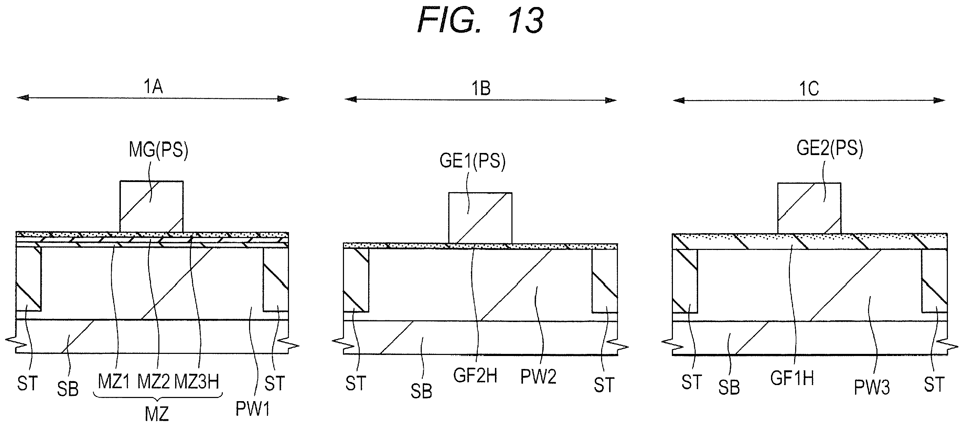

Subsequently, as shown in FIG. 13, the silicon layer PS is patterned using a photolithography technique and an etching technique, thereby the gate electrodes MG, GE1, and GE2 are formed. For example, an undepicted photoresist film formed in each of the region in which the gate electrode MG is to be formed, the region in which the gate electrode GE1 is to be formed, and the region in which the gate electrode GE2 is to be formed. The photoresist film is then used as an etching mask to pattern the silicon layer PS by etching (preferably dry etching). Subsequently, the photoresist film is removed.

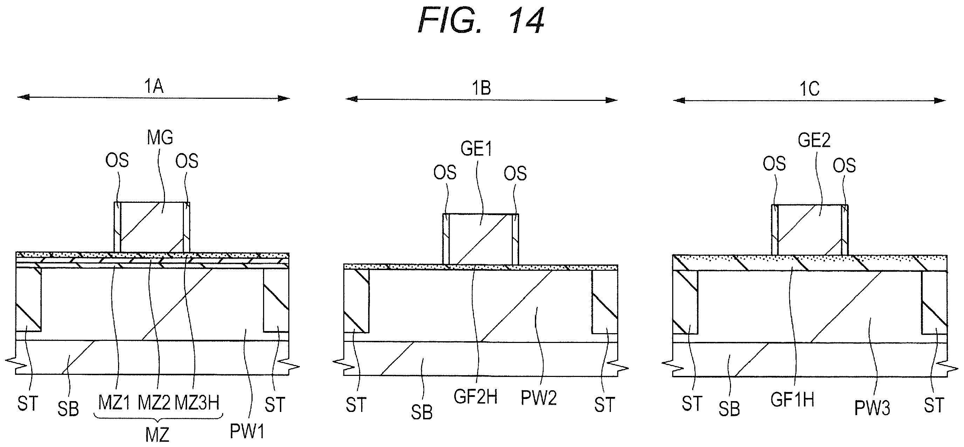

Subsequently, an insulating film (for example, a silicon oxide film or a stacked film of a silicon nitride film and a silicon oxide film) for formation of an offset spacer OS is formed using a CVD process or the like so as to cover the gate electrodes MG, GE1, and GE2 on the entire main surface of the semiconductor substrate SB, and then the insulating film for formation of the offset spacer OS is etched back by an anisotropic etching technique. Consequently, as shown in FIG. 14, the offset spacer (sidewall insulating film) OS is formed on each of the sidewalls of the gate electrodes MG, GE1, and GE2. In another aspect, the offset spacer OS may not be formed.

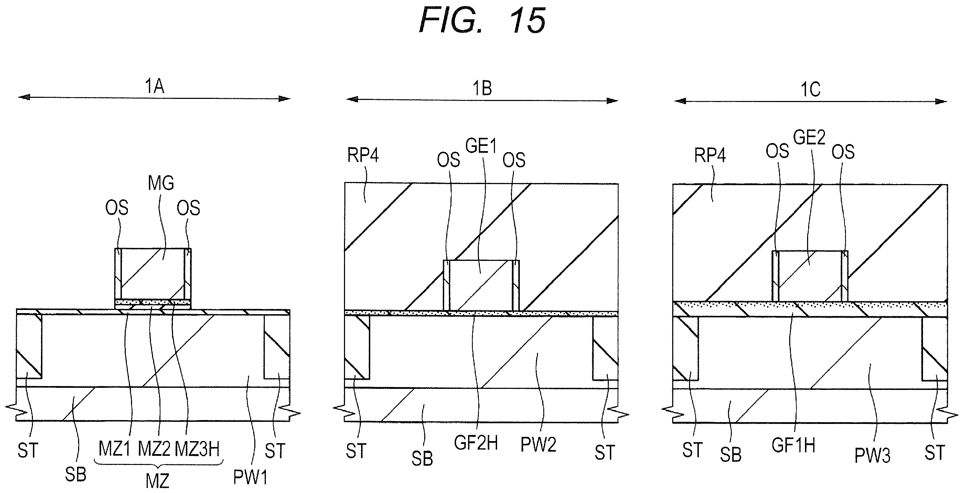

Subsequently, as shown in FIG. 15, a photoresist film PR4 is formed as a mask layer on the semiconductor substrate SB using a photolithography technique. The photoresist film PR4 covers the low-withstand-voltage MISFET formation region 1B and the high-withstand-voltage MISFET formation region 1C, and exposes the memory region 1A.

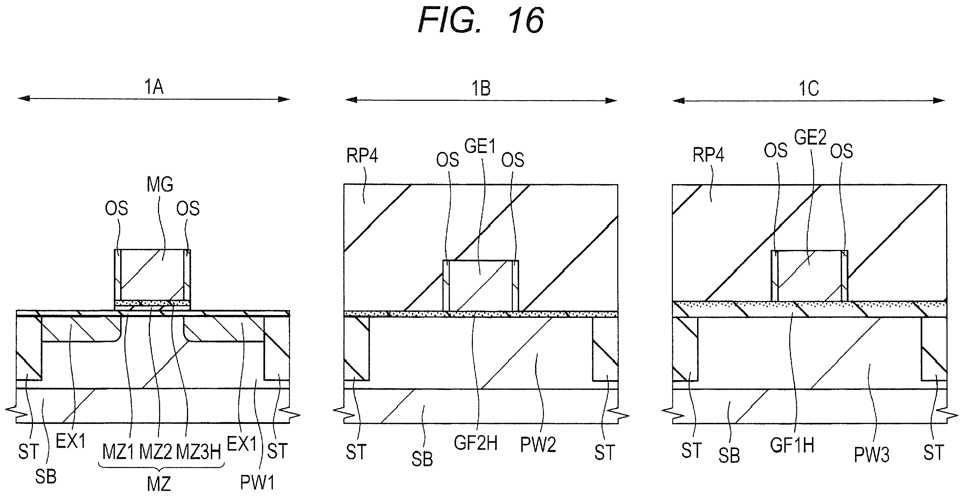

Subsequently, as shown in FIG. 16, the insulating films MZ3H and MZ2 in a portion that is not covered with the gate electrode MG are removed by etching in the memory region 1A. Anisotropic dry etching may be used for such etching. The insulating film MZ1 is preferably left in a layer so as to serve as an etching stopper film.

Subsequently, the n⁻-type semiconductor region EX1 is formed in the semiconductor substrate SB (p-type well PW1) in the memory region 1A by an ion implantation process or the like.

Specifically, an n-type impurity such as phosphorous (P) or arsenic (As) is ion-implanted into the regions of the p-type well PW1 on both sides of the gate electrode MG in the memory region 1A to form the n⁻-type semiconductor region EX1. Since the gate electrode MG and the offset spacer OS serve as a mask during the ion implantation forming the n⁻-type semiconductor region EX1, the n⁻-type semiconductor region EX1 is formed so as to be self-aligned with the offset spacer OS on the sidewall of the gate electrode MG. Subsequently, the photoresist film PR4 is removed.

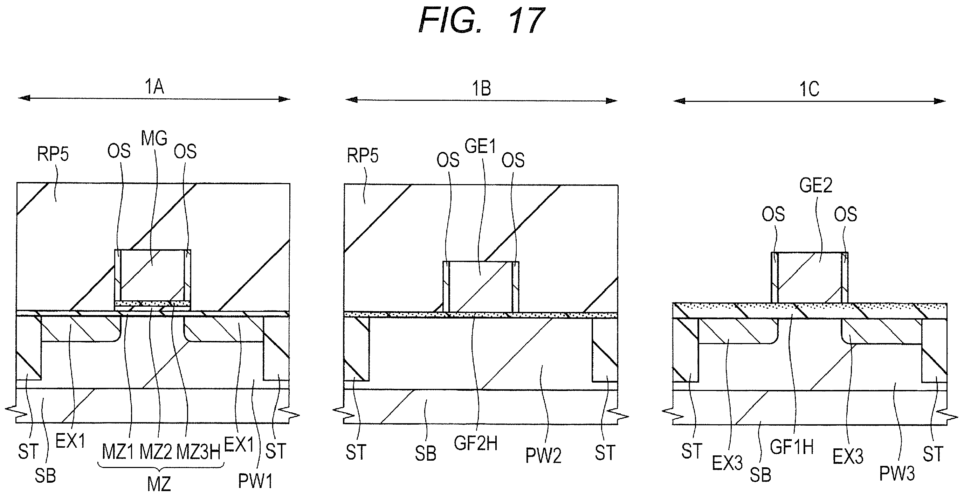

Subsequently, as shown in FIG. 17, a photoresist film PR5 is formed as a mask layer on the semiconductor substrate SB so as to cover the memory region 1A and the low-withstand-voltage MISFET formation region 1B. Subsequently, the n⁻-type semiconductor region EX3 is formed in the semiconductor substrate SB (p-type well PW3) in the high-withstand-voltage MISFET formation region 1C by an ion implantation process or the like.

Specifically, the n-type impurity such as phosphorous (P) or arsenic (As) is ion-implanted into regions of the p-type well PW3 on both sides of the gate electrode GE2 in the high-withstand-voltage MISFET formation region 1C to form the n⁻-type semiconductor region EX3. Since the gate electrode GE2 and the offset spacer OS serve as a mask for the ion implantation forming the n⁻-type semiconductor region EX3, the n-type semiconductor region EX3 is formed so as to be self-aligned with the offset spacer OS on the sidewall of the gate electrode GE2. Subsequently, the photoresist film PR5 is removed.

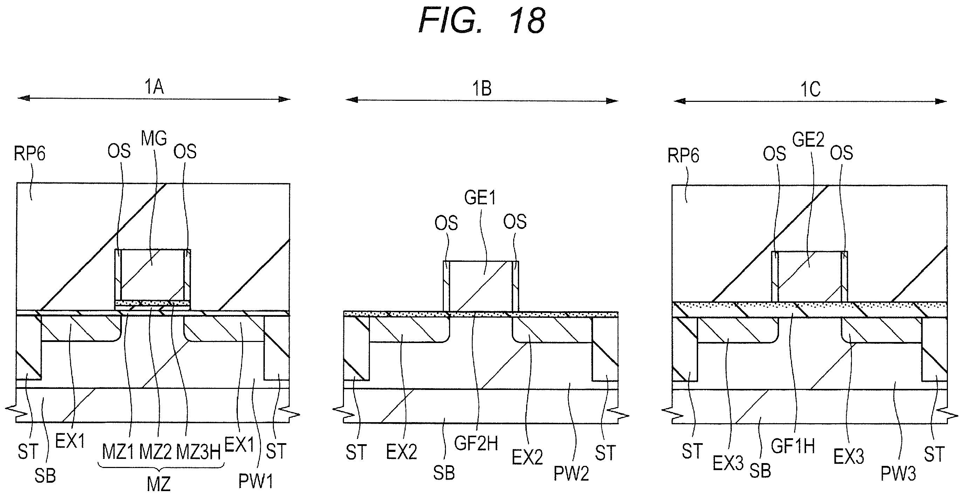

Subsequently, as shown in FIG. 18, a photoresist film PR6 is formed as a mask layer on the semiconductor substrate SB so as to cover the memory region 1A and the high-withstand-voltage MISFET formation region 1C.

Subsequently, as shown in FIG. 18, the n⁻-type semiconductor region EX2 is formed in the semiconductor substrate SB (p-type well PW2) in the low-withstand-voltage MISFET formation region 1B by an ion implantation process or the like.

Specifically, the n-type impurity such as phosphorous (P) or arsenic (As) is ion-implanted into regions of the p-type well PW2 on both sides of the gate electrode GE1 in the low-withstand-voltage MISFET formation region 1B to form the n⁻-type semiconductor region EX2. Since the gate electrode GE1 and the offset spacer OS serve as a mask during the ion implantation forming the n⁻-type semiconductor region EX2, the n-type semiconductor region EX2 is formed so as to be self-aligned with the offset spacer OS on the sidewall of the gate electrode GE1. Subsequently, the photoresist film PR6 is removed.

It is also possible to form any combination of the n⁻-type semiconductor region EX1 in the memory region 1A, the n⁻-type semiconductor region EX2 in the low-withstand-voltage MISFET formation region 1B, and the n⁻-type semiconductor region EX3 in the high-withstand-voltage MISFET formation region 1C in the same ion implantation step.

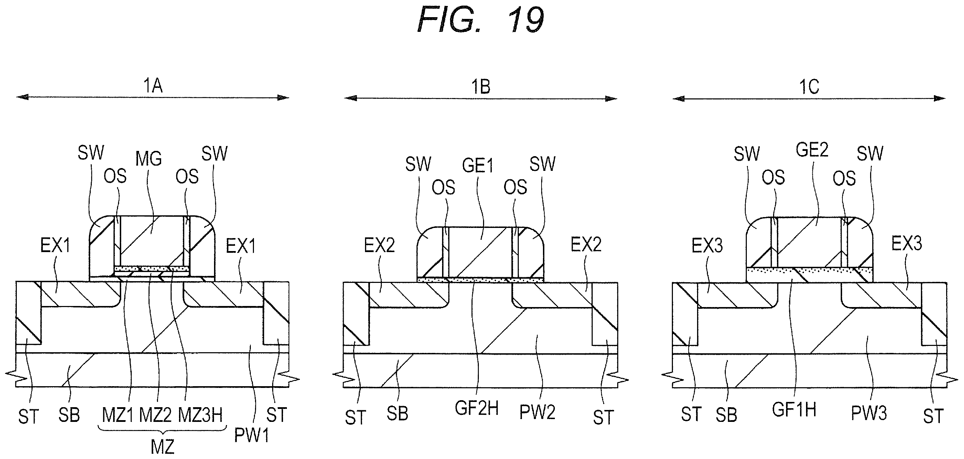

Subsequently, as shown in FIG. 19, the sidewall spacer SW comprising an insulating film is formed as a sidewall insulating film on the sidewall of each of the gate electrodes MG, GE1, and GE2. For example, an insulating film for formation of the sidewall spacer SW is formed using a CVD process or the like so as to cover the gate electrodes MG, GE1, and GE2 on the entire main surface of the semiconductor substrate SB, and then the insulating film is etched back by an anisotropic etching technique. As a result, as shown in FIG. 19, the sidewall spacer SW is formed on the sidewall of each of the gate electrodes MG, GE1, and GE2.

The insulating film GF2 in a portion that is not covered with the gate electrode GE1 and the sidewall spacer SW in the low-withstand-voltage MISFET formation region 1B, and the insulating film GF1 in a portion that is not covered with the gate electrode GE2 and the sidewall spacer SW in the high-withstand-voltage MISFET formation region 1C may be removed in the etch back step for forming the sidewall spacers SW. The insulating film MZ1 in a portion that is not covered with the gate electrode MG and the sidewall spacer SW in the memory region 1A may also be removed in the etch back step for forming the sidewall spacer SW.

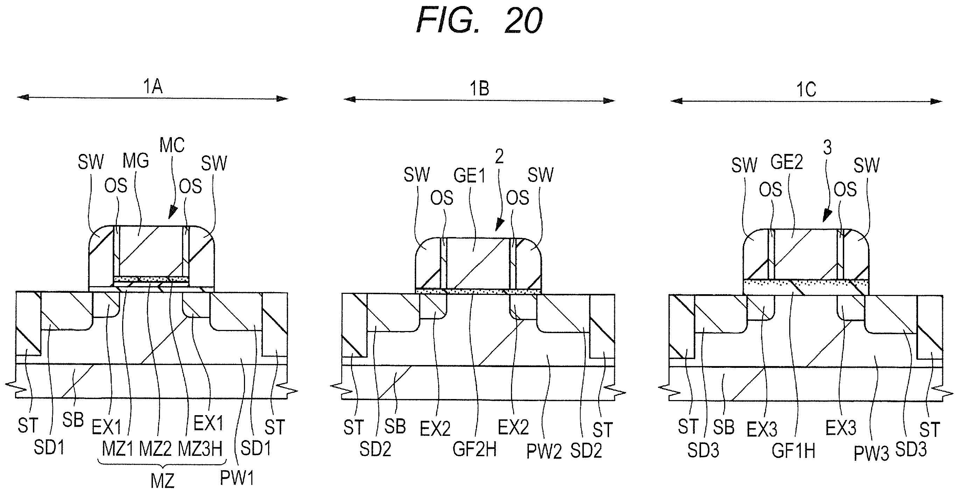

Subsequently, as shown in FIG. 20, an n-type impurity such as phosphorous (P) or arsenic (As) is ion-implanted to form the n⁺-type semiconductor region SD1 in the semiconductor substrate SB (p-type well PW1) in the memory region 1A, and to form the n⁺-type semiconductor region SD2 in the semiconductor substrate SB (p-type well PW2) in the low-withstand-voltage MISFET formation region 1B. In addition, the n⁺-type semiconductor region SD3 is formed in the semiconductor substrate SB (p-type well PW3) in the high-withstand-voltage MISFET formation region 1C. Such regions (SD1, SD2, SD3) are each formed so as to be self-aligned with the side surface of the sidewall spacer SW. Each of the regions has a higher impurity concentration and a deeper junction depth than the n⁻-type semiconductor region.

The n⁺-type semiconductor region SD1 in the memory region 1A, the n⁺-type semiconductor region SD2 in the low-withstand-voltage MISFET formation region 1B, and the n⁺-type semiconductor region SD3 in the high-withstand-voltage MISFET formation region 1C may also be formed in the same ion implantation step or in different ion implantation steps.

Subsequently, activation anneal is performed as heat treatment to activate the impurities that have been introduced.

In this way, the memory cell MC is formed in the memory region 1A, the low-withstand-voltage MISFET2 is formed in the low-withstand-voltage MISFET formation region 1B, and the high-withstand-voltage MISFET3 is formed in the high-withstand-voltage MISFET formation region 1C.

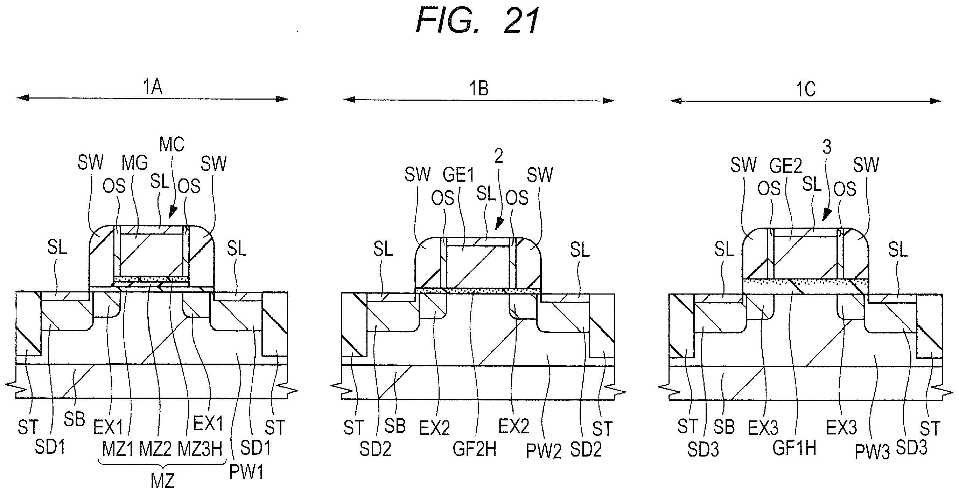

Subsequently, as shown in FIG. 21, a metal silicide layer SL is formed by a self aligned silicide (salicide) process. For example, a metal film for formation of the metal silicide layer SL is formed on the main surface of the semiconductor substrate SB so as to cover the gate electrodes MG, GE1, and GE2 and the sidewall spacers SW. The metal film comprises, for example, a cobalt film, a nickel film, or a nickel platinum alloy film. Subsequently, the semiconductor substrate SB is subjected to heat treatment to react each of the upper portions of the n⁺-type semiconductor regions SD1, SD2, and SD3 and the upper portions of the gate electrodes MG, GE1, and GE2 with the metal film. As a result, as shown in FIG. 21, the metal silicide layer SL is formed in each of the upper portions of the n⁺-type semiconductor regions SD1, SD2, and SD3 and each of the upper portions of the gate electrodes MG, GE1, and GE2. Subsequently, the unreacted metal film is removed. The metal silicide layer SL may not be formed.

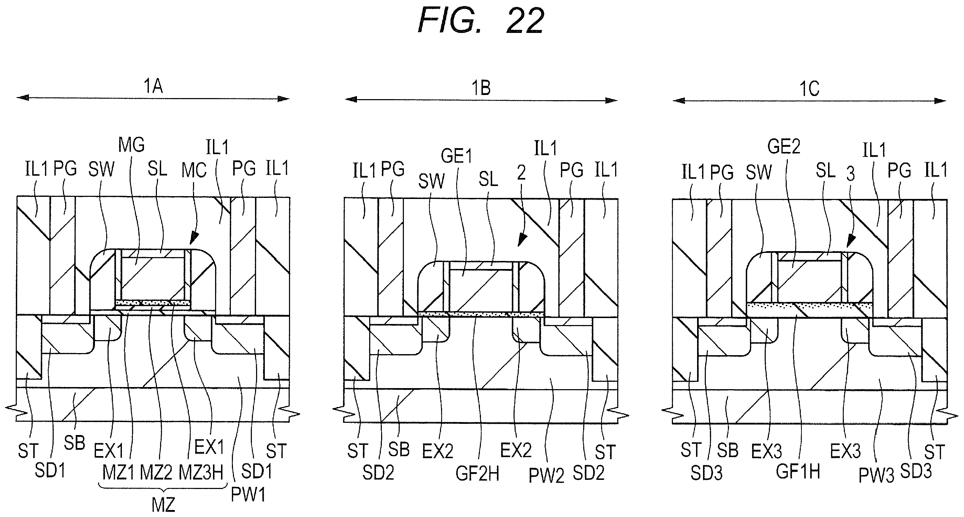

Subsequently, as shown in FIG. 22, an insulating film IL1 is formed as an interlayer insulating film on the entire main surface of the semiconductor substrate SB so as to cover the gate electrodes MG, GE1, and GE2 and the sidewall spacers SW. A single silicon oxide film or a stacked film of a silicon nitride film and a thick silicon oxide film on the silicon nitride film can be used as the insulating film IL1. After formation of the insulating film IL1, if necessary, the top of the insulating film IL1 may be planarized through polishing by a chemical mechanical polishing (CMP) process.

Subsequently, the insulating film IL1 is dry-etched using a photolithography technique with an etching mask comprising an undepicted photoresist film formed on the insulating film IL1 to form contact holes in the insulating film IL1. Subsequently, a conductive plug PG comprising tungsten (W) or the like is formed in each contact hole. For example, a barrier conductor film and a tungsten film are formed in order over the insulating film IL1 comprising the insides of the contact holes, and then the unnecessary main conductor film and barrier conductor film outside each contact hole are removed by a CMP process or an etch back process, thereby the plugs PG are formed. The plug PG is electrically coupled to the metal silicide layer SL on each of the n⁺-type semiconductor regions SD1, SD2, and SD3, or to the metal silicide layer SL on each of the gate electrodes MG, GE1, and GE2.

Subsequently, as shown in FIG. 23, an insulating film IL2 is formed over the insulating film IL1 in which the plugs PG are embedded, and then interconnection trenches are formed in predetermined regions in the insulating film IL2, and then interconnections M1 are embedded in the interconnection trenches using a single damascene technique. For example, the interconnection M1 is a copper interconnection (embedded copper interconnection) mainly containing copper. The interconnection M1 is electrically coupled to each of the n⁺-type semiconductor regions SD1, SD2, and SD3 or each of the gate electrodes MG, GE1, and GE2 via the plug PG.

Subsequently, interconnections of second and subsequent layers are formed by a dual damascene process or the like, which are not illustrated nor described herein. The interconnection M1 and any upper-layer interconnection are each not limited to the damascene interconnection, and may be formed by patterning a conductive film for an interconnection. In addition, such an interconnection may be a tungsten interconnection or an aluminum interconnection, for example.

In this way, the semiconductor device of the first embodiment is manufactured.

### Second Embodiment

In a second embodiment, various application examples are described. A semiconductor device of each application example described in the second embodiment has components similar to those in the first embodiment, and the components can be formed in manufacturing processes similar to those in the first embodiment. Hence, the components similar to those in the first embodiment and the manufacturing processes of the components are not repeatedly described or are simply described.

### First Application Example

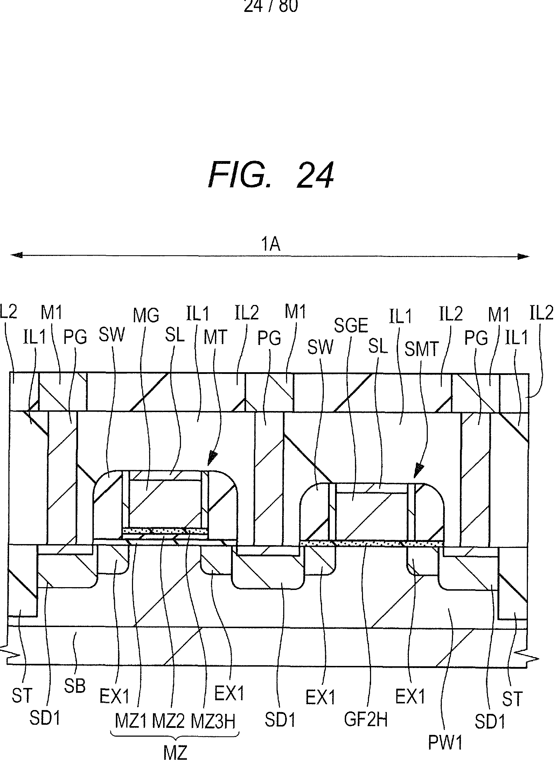

The memory cell may be configured of a memory transistor MT and a selection transistor SMT. FIG. 24 is a major-part sectional view illustrating a memory region of a semiconductor device of a first application example. As shown in FIG. 24, the memory cell of the first application example is configured of the memory transistor MT and the selection transistor SMT. The memory transistor MT and the selection transistor SMT are coupled in series to each other.

The memory transistor MT has a configuration similar to that of the memory cell MC in the first embodiment (FIG. 23). The selection transistor SMT has a configuration similar to that of the low-withstand-voltage MISFET2 in the first embodiment. The gate electrode MG of the memory transistor MT and a selection gate electrode SG of the selection transistor SMT are disposed so as to extend side by side in the same direction. In FIG. 24, n-type semiconductor regions for a source or drain of each of the memory transistor MT and the selection transistor SMT are shown as an n⁻-type semiconductor region EX1 and an n⁺-type semiconductor region SD1. The n-type semiconductor region for the source or the drain is shared by the memory transistor MT and the selection transistor SMT. The memory transistor MT and the selection transistor SMT can be formed in the same way as in the memory cell MC and the low-withstand-voltage MISFET2, respectively, in the first embodiment (FIG. 23). The manufacturing process described in a third embodiment will serve as a reference for the manufacturing process of the memory transistor MT and the election transistor SMT.

### Second Application Example

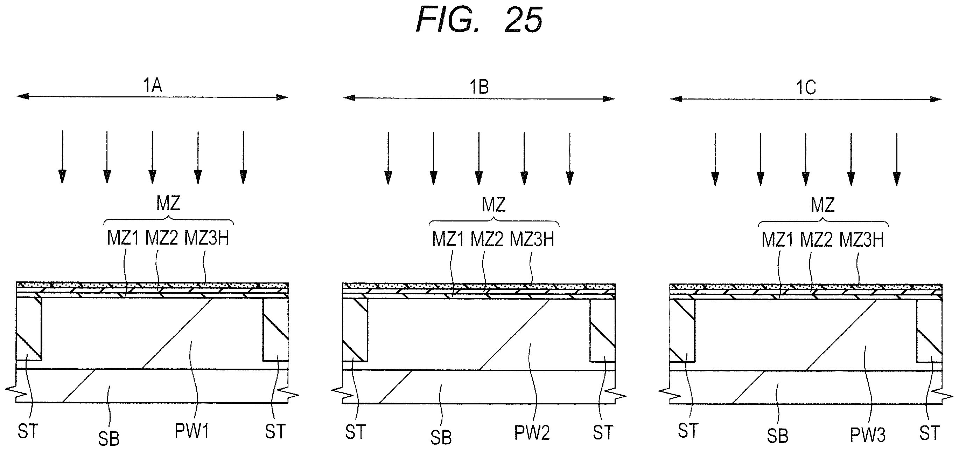

In the first embodiment, as shown in FIG. 11, the metal or the metal oxide has been simultaneously added (by sputtering) onto the insulating films (insulating films MZ3, GF2, and GF1). However, the metal or the metal oxide may be added for each insulating film. FIGS. 25 to 33 are each a major-part sectional view of the semiconductor device of the second application example during a manufacturing process of the semiconductor device.

For example, as shown in FIG. 25, the insulating film (stacked insulating film) MZ is formed on the surface (comprising the surfaces of the p-type wells PW1, PW2, and PW3) of the semiconductor substrate SB in the state as shown in FIG. 4 of the first embodiment. The insulating film MZ comprises a stacked film of the insulating film MZ1, the insulating film MZ2 formed on the insulating film MZ1, and the insulating film MZ3 formed on the insulating film MZ2. Subsequently, addition (deposition processing) of a metal or a metal oxide is performed on the insulating film MZ at a first condition, so that a minute amount of metal atoms or metal oxide molecules are deposited on the insulating film MZ (insulating film MZ3) to form a High-K added layer (insulating film MZ3H).

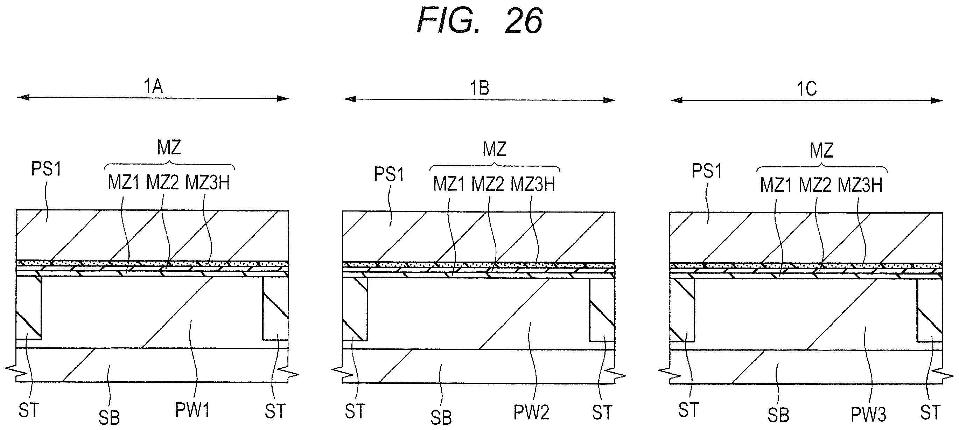

Subsequently, as shown in FIG. 26, a silicon layer PS1 is formed as a film (conductive film) for formation of the gate electrode on the insulating film MZ. The silicon layer PS1 is a film for formation of the gate electrode MG for the memory cell MC.

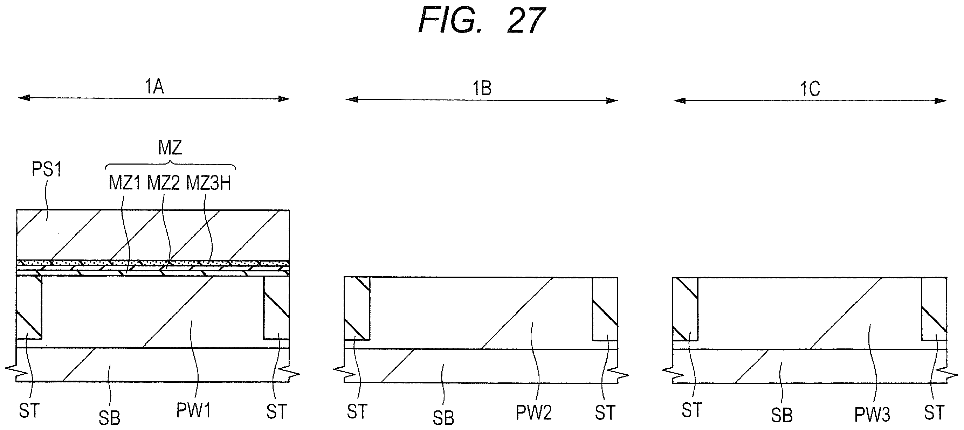

Subsequently, as shown in FIG. 27, the silicon layer PS1 and the insulating film MZ are removed by etching from the low-withstand-voltage MISFET formation region 1B and the high-withstand-voltage MISFET formation region 1C.

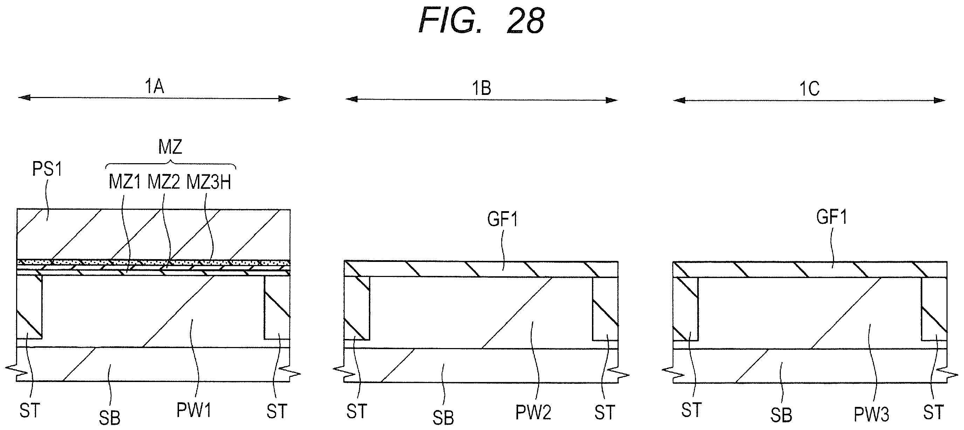

Subsequently, as shown in FIG. 28, an insulating film GF1 is formed by a thermal oxidation process on each of the surfaces (comprising the surfaces of the p-type wells PW2 and PW3) of the semiconductor substrate SB in the low-withstand-voltage MISFET formation region 1B and the high-withstand-voltage MISFET formation region 1C. The insulating film GF1 is an insulating film for the gate insulating film of the MISFET3 to be formed in the high-withstand-voltage MISFET formation region 1C.

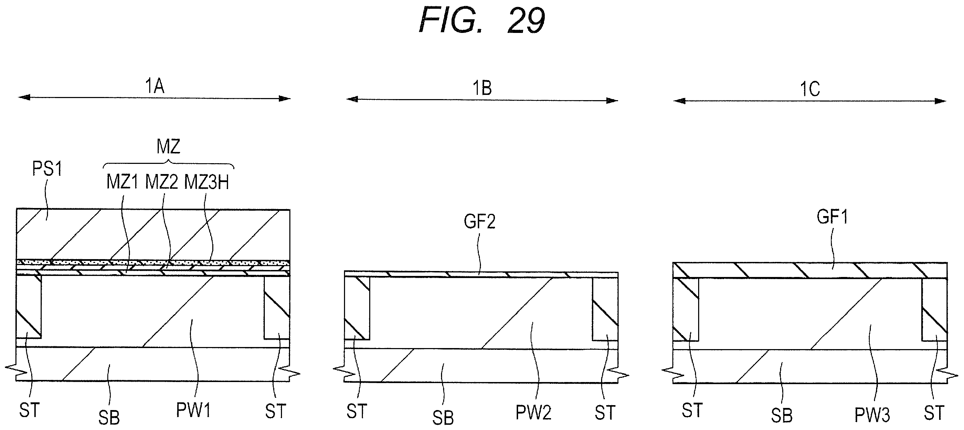

Subsequently, as shown in FIG. 29, the insulating film GF1 in the low-withstand-voltage MISFET formation region 1B is removed by etching, and an insulating film GF2 is formed by a thermal oxidation process on the surface (p-type well PW2) of the semiconductor substrate SB in the low-withstand-voltage MISFET formation region 1B. The insulating film GF2 is an insulating film for the gate insulating film of the MISFET2 to be formed in the low-withstand-voltage MISFET formation region 1B.

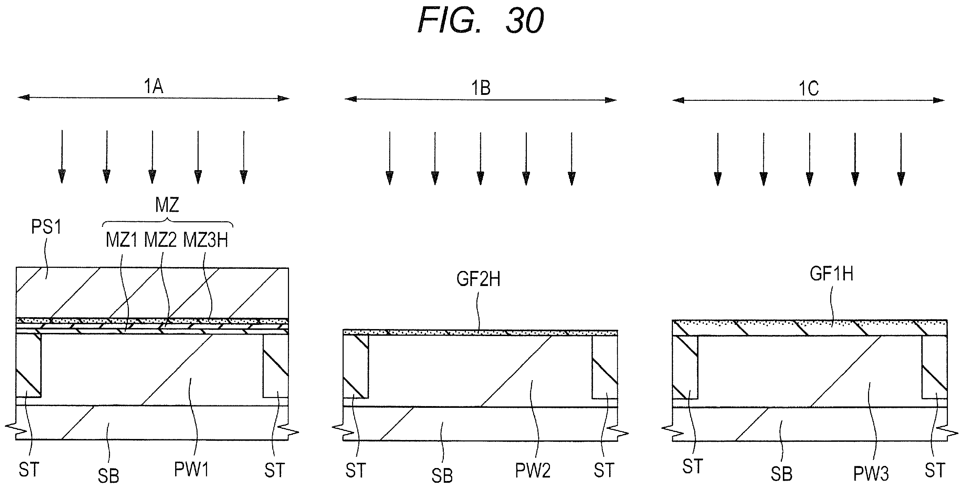

Subsequently, as shown in FIG. 30, addition (deposition processing) of a metal or a metal oxide is performed at a second condition on the insulating films (insulating films GF2 and GF1) in the low-withstand-voltage MISFET formation region 1B and the high-withstand-voltage MISFET formation region 1C, so that a minute amount of metal atoms or metal oxide molecules are deposited on the insulating films (insulating films GF2 and GF1) to form High-K added layers (insulating films GF2H and GF1H).

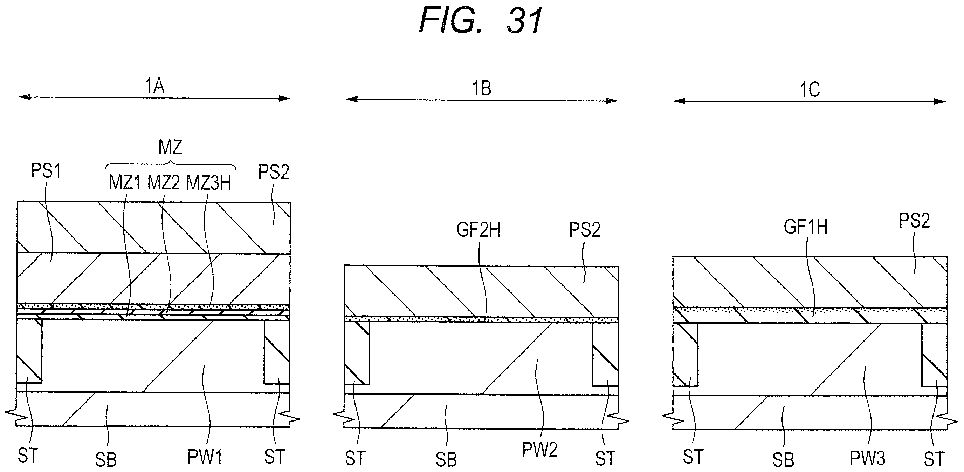

Subsequently, as shown in FIG. 31, a silicon layer PS2 is formed as a film (conductive film) for formation of the gate electrode on the silicon layer PS1 and the insulating films (insulating films GF2H and GF1H). The silicon layer PS2 partly serves as a film for formation of the gate electrode GE1 for the MISFET2 and partly serves as a film for formation of the gate electrode GE2 for the MISFET3.

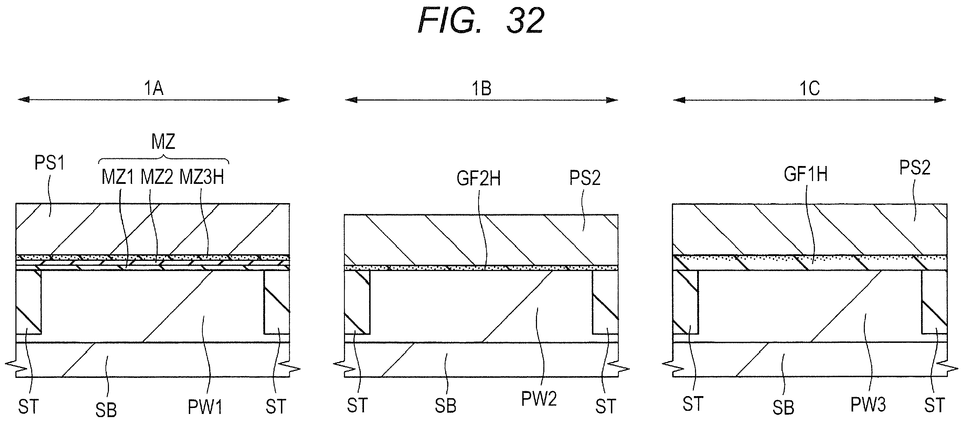

Subsequently, as shown in FIG. 32, the silicon layer PS2 on the silicon layer PS1 is removed. After that, the semiconductor device may be formed through steps similar to those described with reference to FIGS. 12 to 23 in the first embodiment.

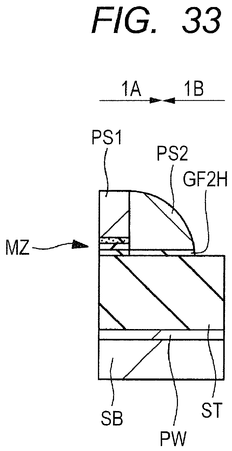

In the second application example, since two silicon layers PS1 and PS2 are used, as shown in FIG. 33, the silicon layer PS2 may remain in a sidewall shape on a sidewall of the silicon layer PS1 at a boundary portion between the memory region 1A and the low-withstand-voltage MISFET formation region 1B.

In this way, addition (deposition processing) of the metal or the metal oxide is performed at different conditions (first and second conditions) between the memory region 1A and the low-withstand-voltage MISFET formation region 1B as well as the high-withstand-voltage MISFET formation region 1C, thereby an appropriate amount of the metal or the metal oxide can be added depending on the characteristics of the cells (memory cell, MISFET2, MISFET3) formed in the respective regions.

### Third Application Example

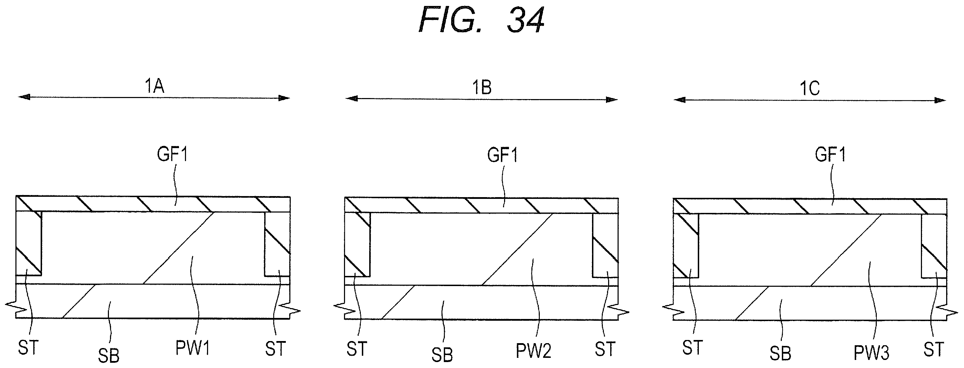

In the first embodiment, as shown in FIG. 11, the metal or the metal oxide has been simultaneously added (by sputtering) onto the insulating films (insulating films MZ3, GF2, and GF1). However, the metal or the metal oxide may also be added for each insulating film. FIGS. 34 to 43 are each a major-part sectional view of a semiconductor device of a third application example during a manufacturing process of the semiconductor device.

For example, as shown in FIG. 34, the insulating film GF1 is formed by a thermal oxidation process on the surface (comprising the surfaces of the p-type wells PW1, PW2, and PW3) of the semiconductor substrate SB in the state as shown in FIG. 4 of the first embodiment. The insulating film GF1 is an insulating film for the gate insulating film of the MISFET3 to be formed in the high-withstand-voltage MISFET formation region 1C.

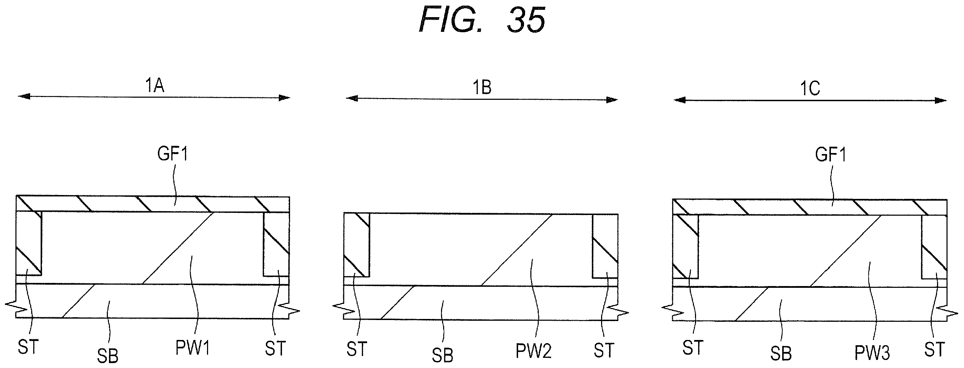

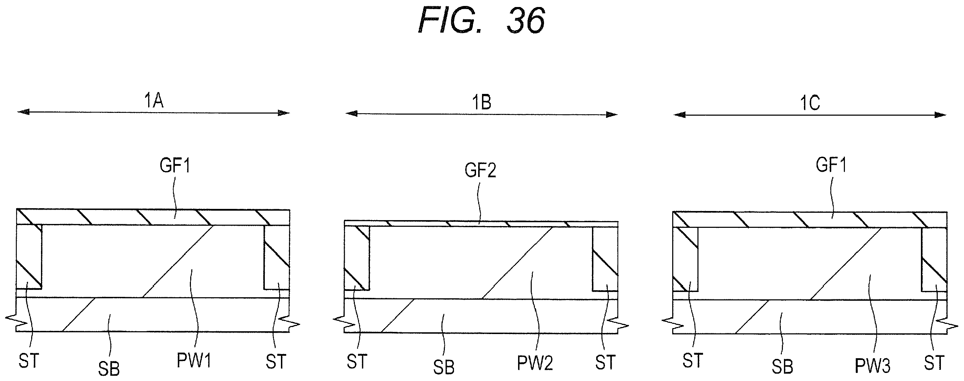

Subsequently, as shown in FIG. 35, the insulating film GF1 in the low-withstand-voltage MISFET formation region 1B is removed by etching. Subsequently, as shown in FIG. 36, the insulating film GF2 is formed by a thermal oxidation process on the surface (p-type well PW2) of the semiconductor substrate SB in the low-withstand-voltage MISFET formation region 1B. The insulating film GF2 is an insulating film for the gate insulating film of the MISFET2 to be formed in the low-withstand-voltage MISFET formation region 1B.

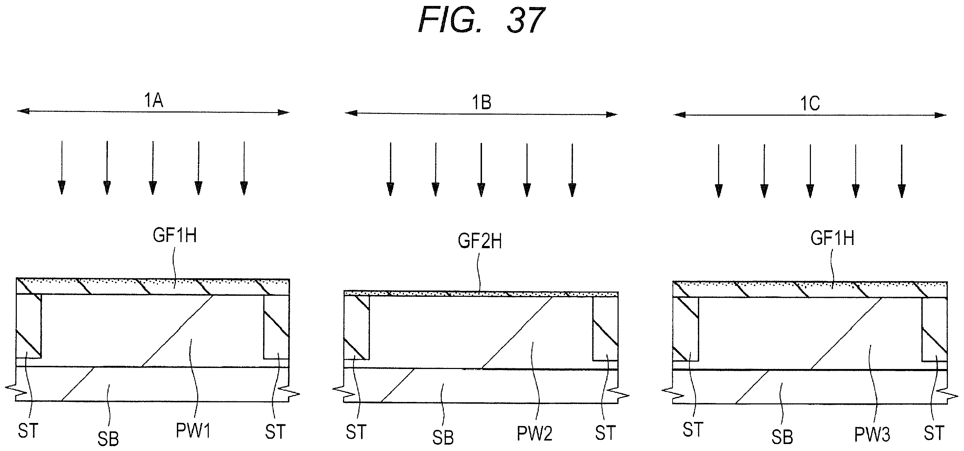

Subsequently, as shown in FIG. 37, addition (deposition processing) of a metal or a metal oxide is performed at a first condition on the insulating films (insulating films GF2 and GF1) in the low-withstand-voltage MISFET formation region 1B and the high-withstand-voltage MISFET formation region 1C, so that a minute amount of metal atoms or metal oxide molecules are deposited on the insulating film MZ (insulating film MZ3) to form High-K added layers (insulating films GF2H and GF1H).

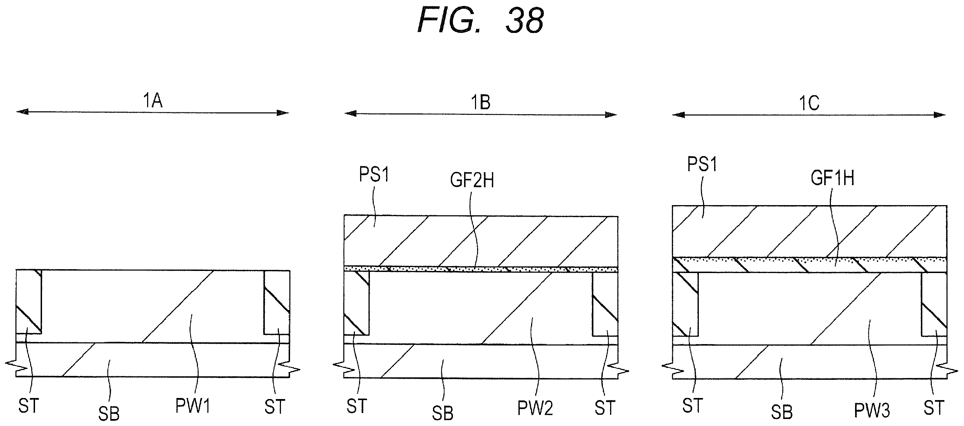

Subsequently, as shown in FIG. 38, a silicon layer PS1 is formed as a film (conductive film) for formation of the gate electrode on the main surface (entire main surface) of the semiconductor substrate SB, and the silicon layer PS1 and the insulating film GF1H are removed by etching from the memory region 1A. The silicon layer PS1 partly serves as a film for formation of the gate electrode GE1 for the MISFET2 and partly serves as a film for formation of the gate electrode GE2 for the MISFET3.

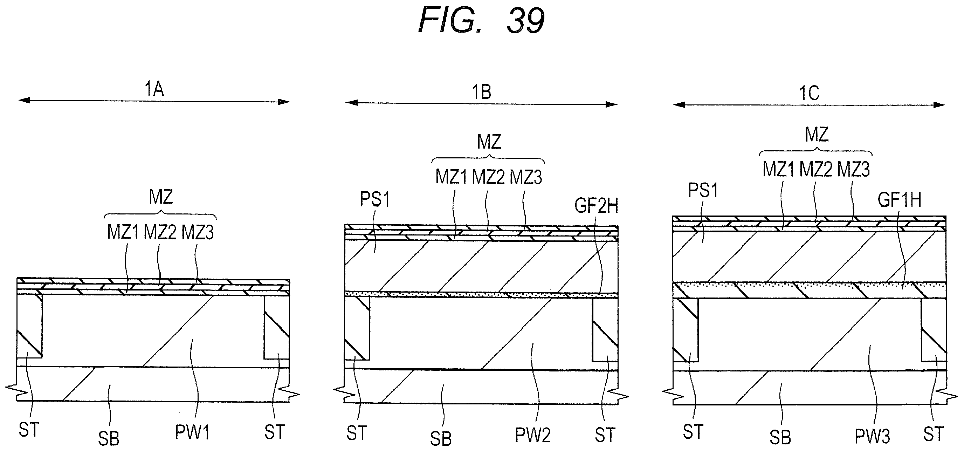

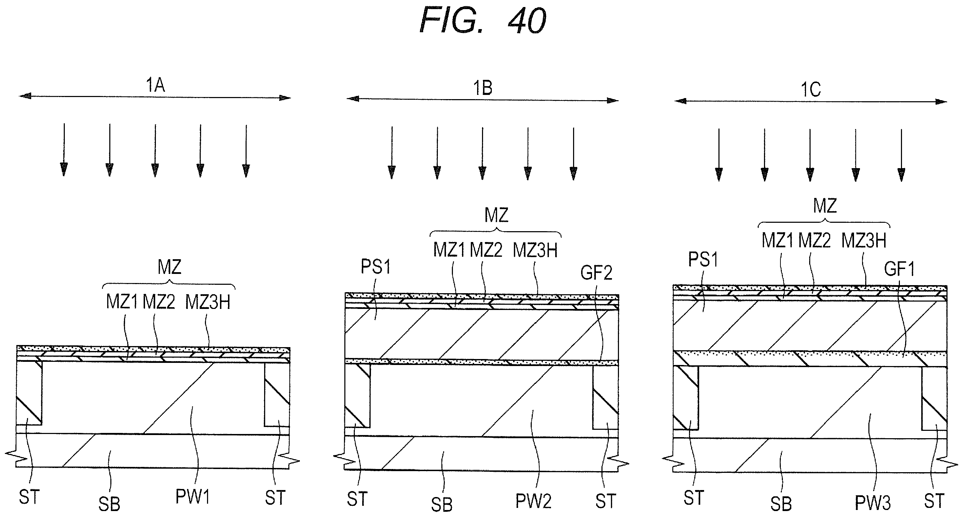

Subsequently, as shown in FIG. 39, the insulating film (stacked insulating film) MZ is formed on the surface (p-type well PW1) of the semiconductor substrate SB. The insulating film MZ comprises a stacked film of the insulating film MZ1, the insulating film MZ2 formed on the insulating film MZ1, and the insulating film MZ3 formed on the insulating film MZ2. Subsequently, as shown in FIG. 40, addition (deposition processing) of a metal or a metal oxide is performed on the insulating film MZ at a second condition, so that a minute amount of metal atoms or metal oxide molecules are deposited on the insulating film MZ (insulating film MZ3) to form a High-K added layer (insulating film MZ3H).

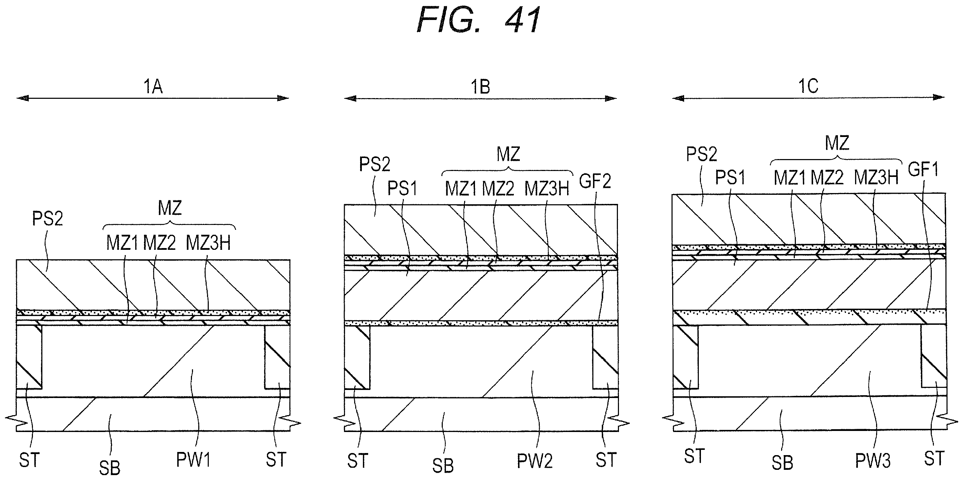

Subsequently, as shown in FIG. 41, a silicon layer PS2 is formed as a film (conductive film) for formation of the gate electrode on the insulating film MZ. The silicon layer PS2 is a film for formation of the gate electrode MG for the memory cell MC.

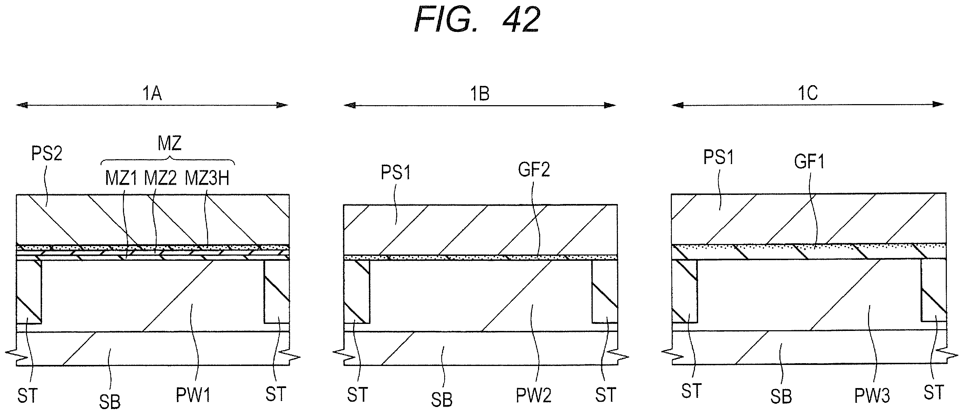

Subsequently, as shown in FIG. 42, the silicon layer PS2 on the silicon layer PS1 is removed. After that, the semiconductor device can be formed through steps similar to those described with reference to FIGS. 12 to 23 in the first embodiment.

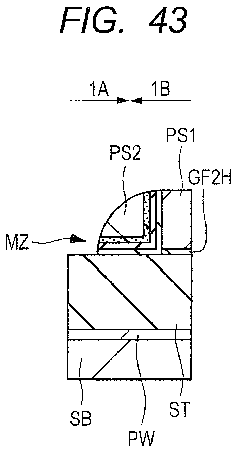

In the third application example, since two silicon layers PS1 and PS2 are used, as shown in FIG. 43, a stacked film of the insulating film MZ and the silicon layer PS2 may remain in a sidewall shape on a sidewall of the silicon layer PS1 at a boundary portion between the memory region 1A and the low-withstand-voltage MISFET formation region 1B.

In this way, addition (deposition processing) of the metal or the metal oxide is performed at different conditions (first and second conditions) between the memory region 1A and the low-withstand-voltage MISFET formation region 1B as well as the high-withstand-voltage MISFET formation region 1C, thereby an appropriate amount of the metal or the metal oxide can be added depending on the characteristics of the cells (memory cell, MISFET2, MISFET3) formed in the respective regions.

### Third Embodiment

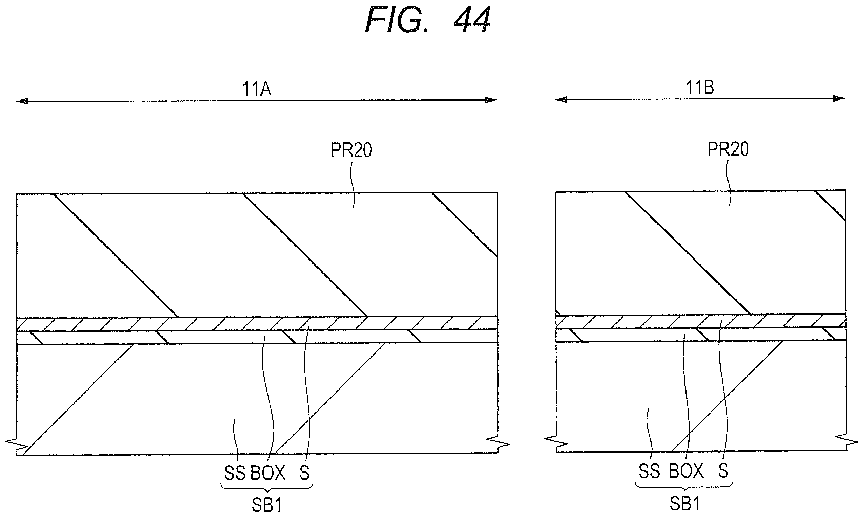

In a third embodiment, a semiconductor device having a memory cell formed on a SOI substrate is described. FIGS. 44 to 79 are each a major-part sectional view of a semiconductor device of the third embodiment during a manufacturing process of the semiconductor device. A semiconductor device described in the third embodiment has components similar to those in the first and second embodiments, and the components can be formed in manufacturing steps similar to those in the first or second embodiment. Hence, the components and the manufacturing steps of the components similar to those in the first or second embodiment are not repeatedly described or are simply described.

### Description of Structure

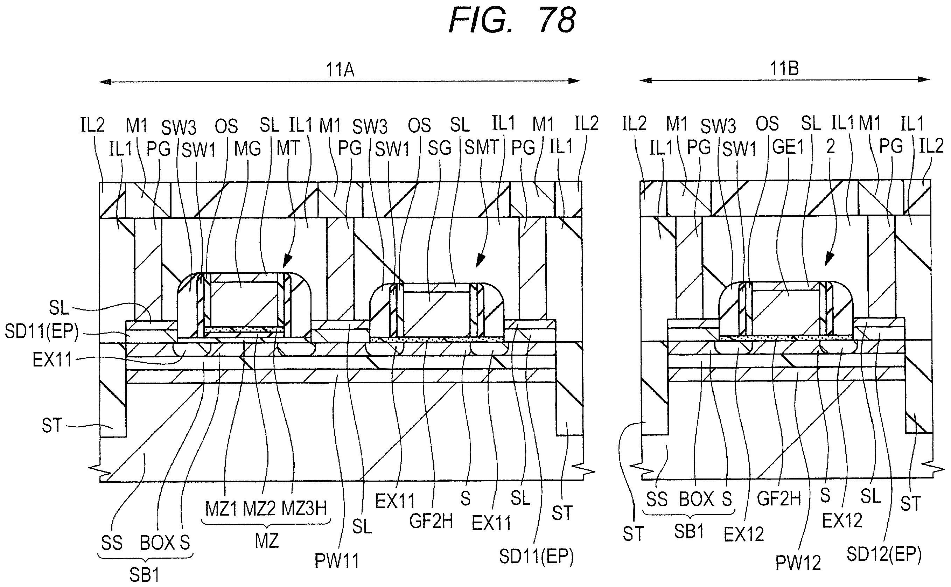

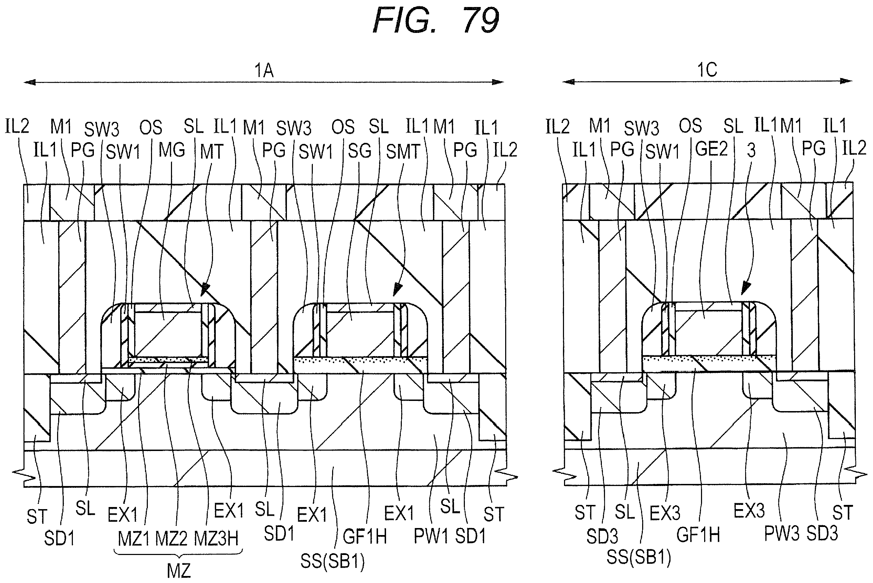

As shown in FIGS. 78 and 79 illustrating the final step among the drawings illustrating the manufacturing steps, the semiconductor device of the third embodiment comprises a memory transistor MT, a selection transistor SMT, and a low-withstand-voltage MISFET2 formed in a SOI region (11A, 11B) of an SOI substrate SB1, and comprises a memory transistor MT, a selection transistor SMT, and a high-withstand-voltage MISFET3 formed in a bulk region (1A, 1C).

In the SOI region (11A, 11B), a silicon layer (also referred to as SOI layer, semiconductor layer, semiconductor film, thin semiconductor film, or thin semiconductor region) S is disposed on a support substrate SS with an insulating layer BOX in between. The memory transistor MT, the selection transistor SMT, and the low-withstand-voltage MISFET2 are formed in the silicon layer S (FIG. 78).

In the bulk region (1A, 1C), the insulating layer BOX and the silicon layer S are not formed on the support substrate SS. Hence, the memory transistor MT, the selection transistor SMT, and the high-withstand-voltage MISFET3 are formed on the main surface of the support substrate SS (FIG. 79). The configuration of each of the memory transistor MT, the selection transistor SMT, and the high-withstand-voltage MISFET3 in the bulk region (1A, 1C) as shown in FIG. 79 is the same as that of each of the memory transistor MT, the selection transistor SMT, and the high-withstand-voltage MISFET3 described in the first and second embodiments.

As shown in FIG. 78, the memory transistor MT in the SOI region (11A, 11B) comprises an insulating film MZ formed on the silicon layer S of the SOI substrate in the memory region 11A, and a gate electrode (memory gate electrode) MG formed on the insulating film MZ. Specifically, the gate electrode MG is formed on the surface of the silicon layer S in the memory region 11A with the insulating film MZ, which has a charge storage part and serves as a gate insulating film, in between. The memory transistor MT further comprises an offset spacer OS and sidewall spacers SW1 and SW3 formed on a sidewall of the gate electrode MG, and n-type semiconductor regions (n⁻-type semiconductor region EX11 and n⁺-type semiconductor region SD11) for a source or a drain formed in the silicon layer S on both sides of the gate electrode (memory gate electrode) MG. The n⁺-type semiconductor region is provided in an epitaxial layer EP grown on the silicon layer S on either side of the gate electrode MG.

The insulating film MZ, which serves as a gate insulating film, internally has a charge storage part. The insulating film MZ comprises a stacked film (stacked insulating film) comprising an insulating film MZ1, an insulating film MZ2 formed on the insulating film MZ1, and an insulating film MZ 3H formed on the insulating film MZ2. The insulating film MZ3H is a High-K added layer described in detail in the first embodiment.

The selection transistor SMT is provided in the memory region 11A. The selection transistor SMT comprises an insulating film GF2H formed on the silicon layer S of the SOI substrate in the memory region 11A, and a selection gate electrode SG formed on the insulating film GF2H. That is, the selection gate electrode SG is provided on the surface of the silicon layer S of the SOI substrate in the memory region 11A with the insulating film GF2H serving as a gate insulating film in between. The selection transistor SMT further comprises an offset spacer OS and sidewall spacers SW1 and SW3 formed on a sidewall of the selection gate electrode SG, and n-type semiconductor regions (n⁻-type semiconductor region EX11 and n⁺-type semiconductor region SD11) for a source or a drain formed in the silicon layer S on both sides of the selection gate electrode SG. The n⁺-type semiconductor region is formed in an epitaxial layer EP grown on the silicon layer S on either side of the selection gate electrode SG.

The insulating film GF2H, which serves as a gate insulating film, is a High-K added layer described in detail in the first embodiment.

A low-withstand-voltage MISFET2 is provided in the low-withstand-voltage MISFET formation region 11B of the SOI region (11A, 11B). The low-withstand-voltage MISFET2 comprises an insulating film GF2H formed on the silicon layer S in the low-withstand-voltage MISFET formation region 11B, and a gate electrode GE1 formed on the insulating film GF2H. That is, the gate electrode GE1 is provided on the surface of the silicon layer S of the SOI substrate SB1 in the low-withstand-voltage MISFET formation region 11B with the insulating film GF2H serving as a gate insulating film in between. The low-withstand-voltage MISFET2 further comprises an offset spacer OS and sidewall spacers SW1 and SW3 formed on a sidewall of the gate electrode GE1, and n-type semiconductor regions (n⁻-type semiconductor region EX12 and n⁺-type semiconductor region SD12) for a source or a drain formed in the silicon layer S on both sides of the gate electrode GE1.
The n⁺-type semiconductor region is provided in an epitaxial layer EP grown on the silicon layer S on either side of the gate electrode GE1.

The insulating film GF2H, which serves as a gate insulating film, is a High-K added layer described in detail in the first embodiment.

### Description of Manufacturing Method

A method of manufacturing the semiconductor device of the third embodiment is now described with reference to FIGS. 44 to 79. FIGS. 44 to 79 each illustrate a major-part sectional view of the memory region 11A of the SOI region, the low-withstand-voltage MISFET region 11B of the SOI region, the memory region 1A of the bulk region, and the high-withstand-voltage MISFET region 1C of the bulk region. FIGS. 44 to 79 show an aspect where the memory transistor MT configuring a memory cell of a nonvolatile memory and the section transistor SMT are formed in each of the memory regions 1A and 11A, the low-withstand-voltage MISFET2 is formed in the low-withstand-voltage MISFET formation region 11B, and the high-withstand-voltage MISFET3 is formed in the high-withstand-voltage MISFET formation region 1C.

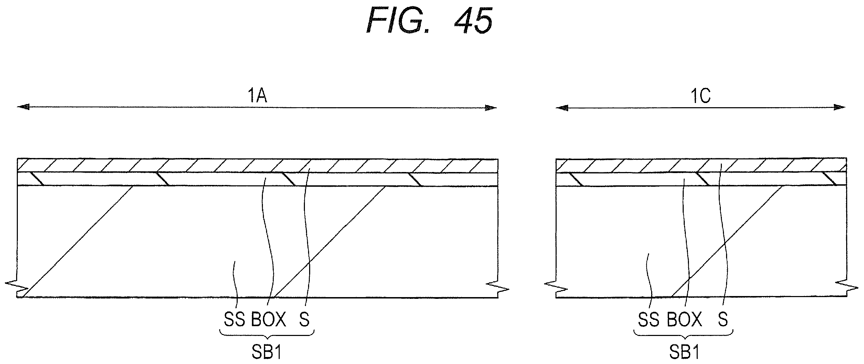

As shown in FIGS. 44 and 45, an SOI substrate SB1, which comprises the support substrate SS, the insulating layer BOX on the support substrate SS, and the silicon layer S on the insulating layer BOX, is provided. The support substrate SS comprises p-type single crystal silicon, or the like. The insulating layer BOX comprises a silicon oxide layer.

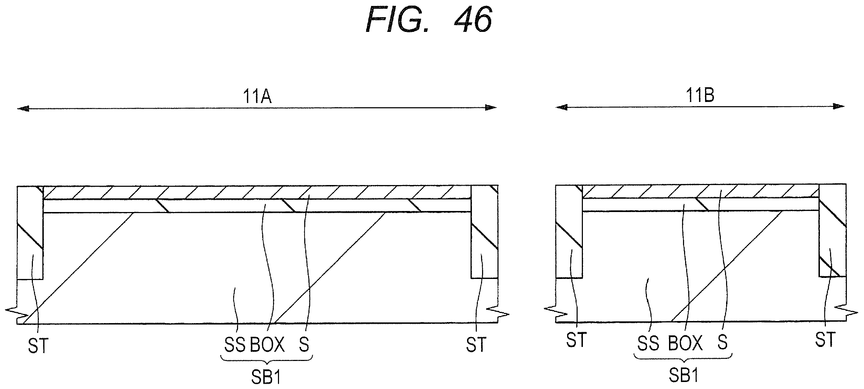

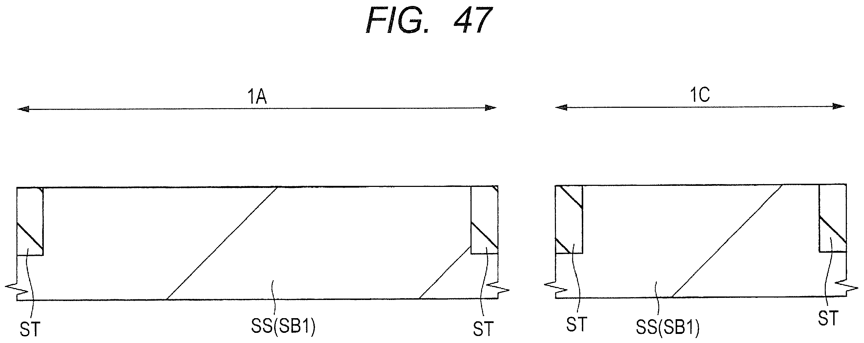

The memory region 11A and the low-withstand-voltage MISFET formation region 11B of such an SOI substrate SB1 are covered with a photoresist film PR20, and the insulating layer BOX and the silicon layer S on the insulating layer BOX are removed by etching from the memory region 1A and the high-withstand-voltage MISFET formation region 1C (FIGS. 46 and 47).

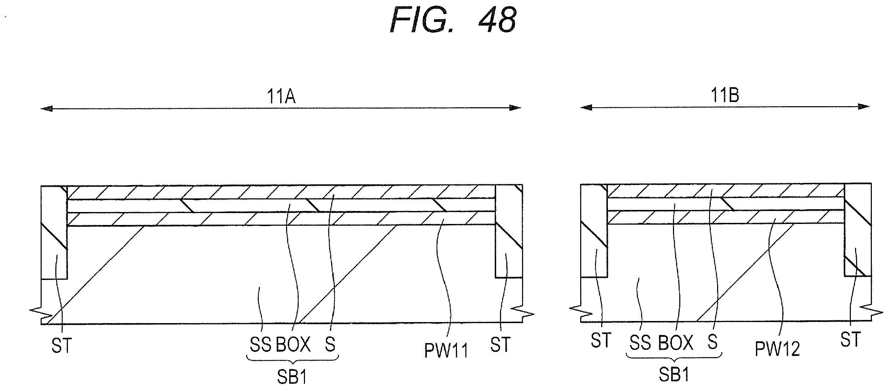

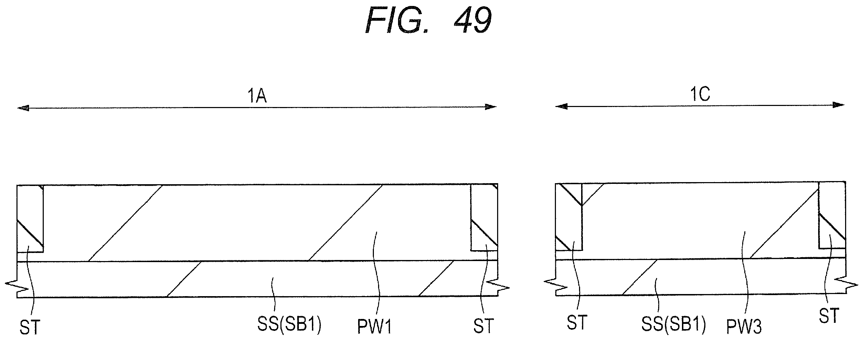

Subsequently, a cell isolation region ST is formed by an STI process, and as shown in FIGS. 48 and 49, an ion implantation process is used to form a p-type well PW1 in the memory region 1A, a p-type well PW3 in the high-withstand-voltage MISFET formation region 1C, a p-type well PW11 on the support substrate SS in the memory region 11A, and a p-type well PW12 on the support substrate SS in the low-withstand-voltage MISFET formation region 11B.

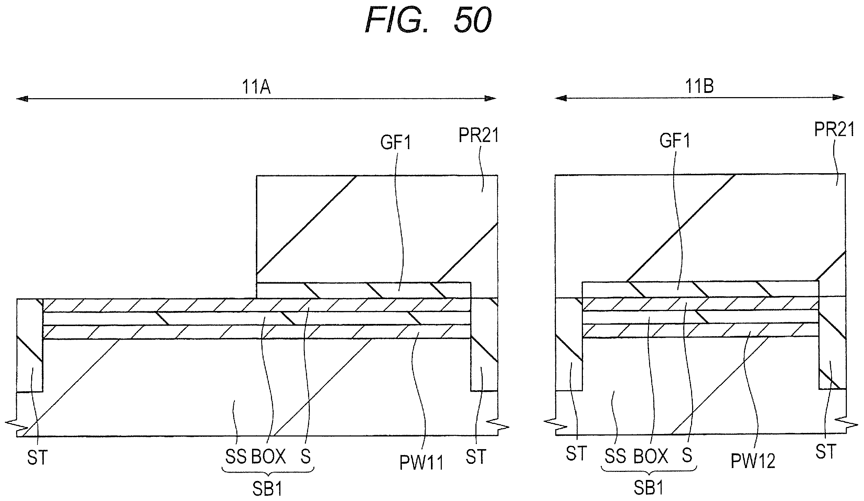

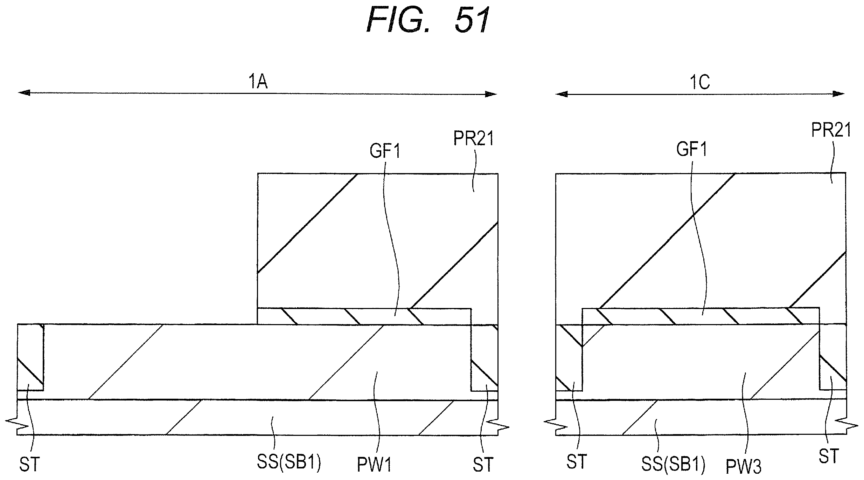

Subsequently, as shown in FIGS. 50 and 51, the insulating film GF1 is formed by a thermal oxidation process on the surfaces of the silicon layer S and the support substrate SS.

Subsequently, a photoresist film PR21 is formed so as to cover formation regions of the selection transistor SMT in the low-withstand-voltage MISFET formation region 11B, the high-withstand-voltage MISFET formation region 1C, and the memory regions 1A and 11A, and the insulating film GF1 is etched using the photoresist film PR21 as an etching mask. Subsequently, the photoresist film PR21 is removed.

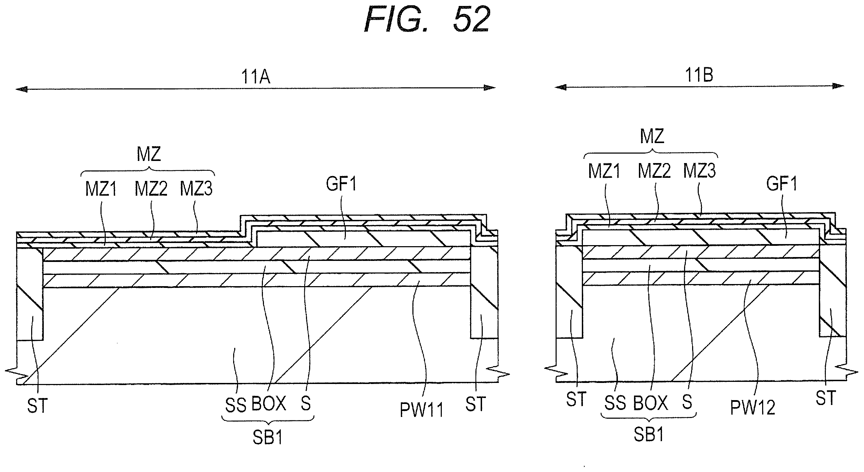

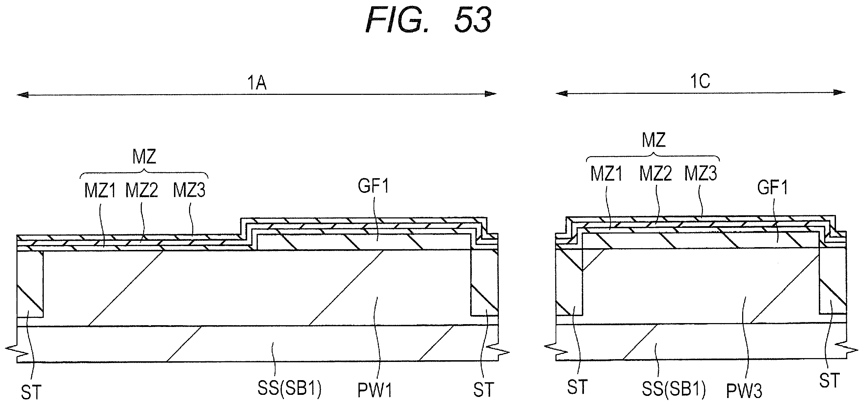

Subsequently, as shown in FIGS. 52 and 53, an insulating film (stacked insulating film) MZ is formed on the insulating film GF1, the silicon layer S, and the p-type well PW1. The insulating film MZ comprises a stacked film of an insulating film MZ1, an insulating film MZ2 formed on the insulating film MZ1, and an insulating film MZ3 formed on the insulating film MZ2. The insulating film MZ1 comprises a silicon oxide film, and may be formed by a thermal oxidation process. The insulating film MZ2 comprises a silicon nitride film, and may be formed by a CVD process. The insulating film MZ3 comprises a silicon oxide film, and may be formed by a CVD process and/or a thermal oxidation process. In the third embodiment, the insulating film MZ1 on the insulating film GF1 is shown.

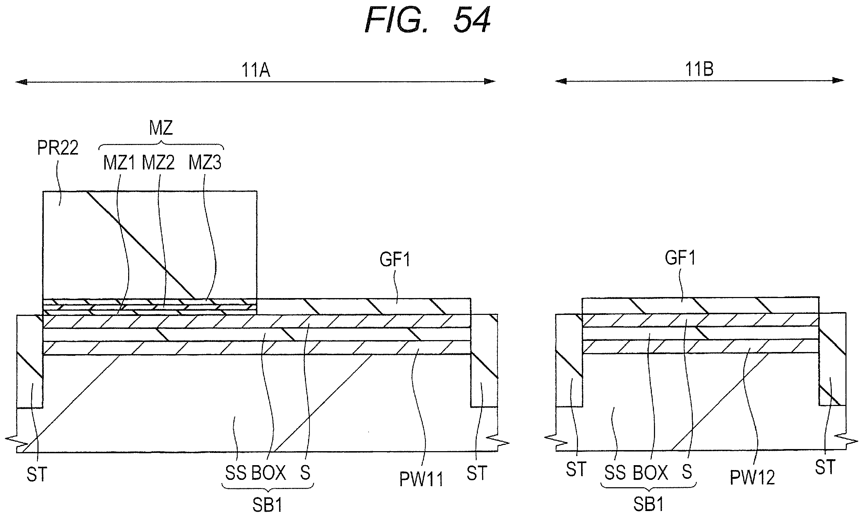

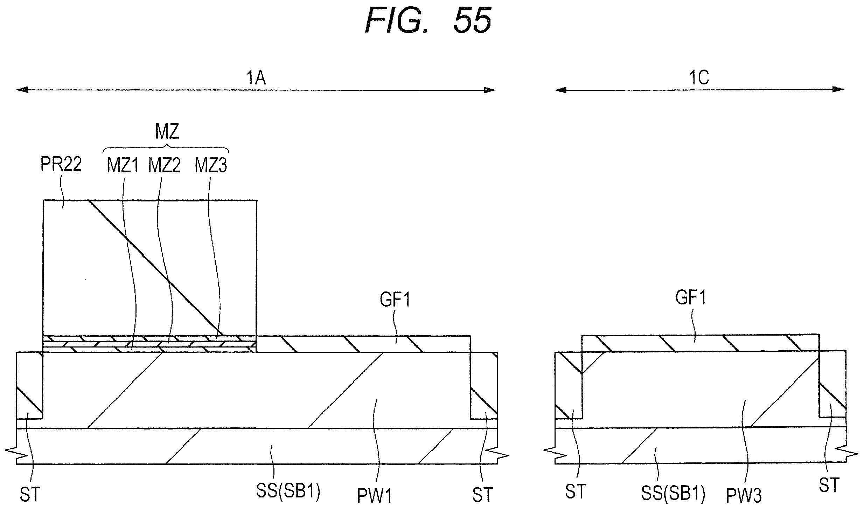

Subsequently, as shown in FIGS. 54 and 55, a photoresist film PR22 is formed so as to cover formation regions of the memory cell in the memory regions 1A and 11A, and the insulating film MZ is etched using the photoresist film PR22 as an etching mask. Subsequently, the photoresist film PR22 is removed.

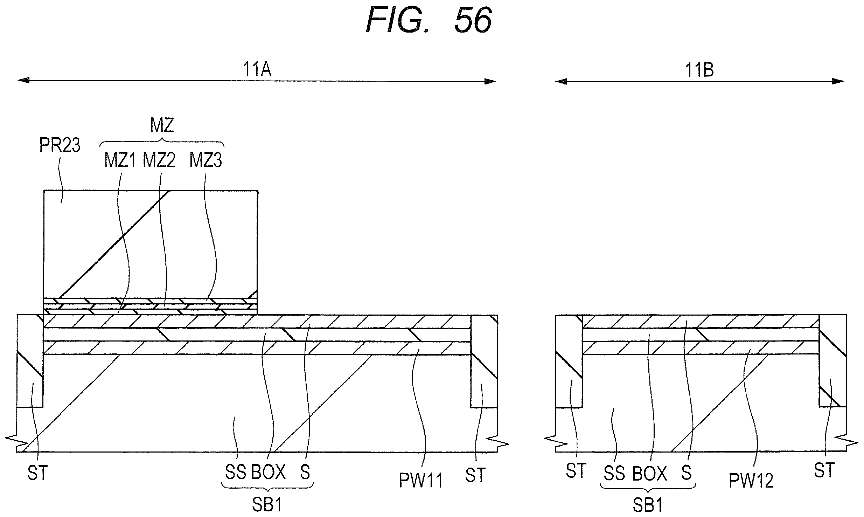

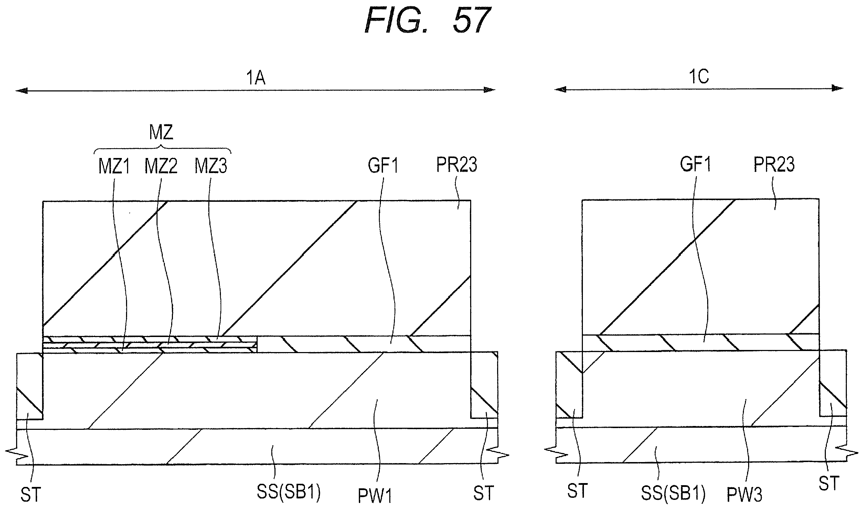

Subsequently, as shown in FIGS. 56 and 57, a photoresist film PR23 having openings in a formation region of the selection transistor SMT in the memory region 11A and in the low-withstand-voltage MISFET formation region 11B is formed, and the insulating film GF1 is etched using the photoresist film PR23 as an etching mask. Subsequently, the photoresist film PR23 is removed.

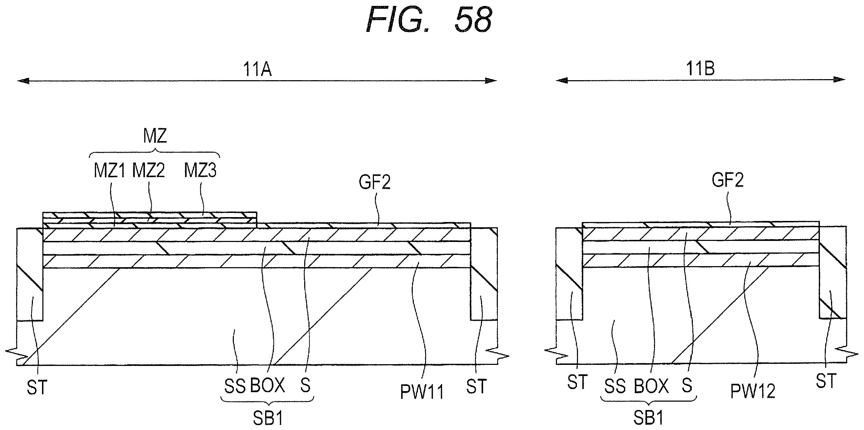

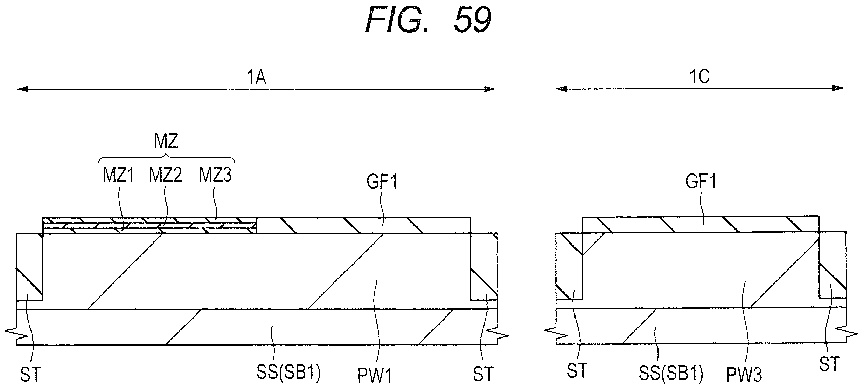

Subsequently, as shown in FIGS. 58 and 59, the insulating film GF2 is formed by a thermal oxidation process or the like over the formation region of the selection transistor SMT in the memory region 11A and over the low-withstand-voltage MISFET formation region 11B.

In this way, the structure of FIGS. 58 and 59 is provided. In the structure of FIG. 58, the insulating film MZ comprising the stacked film of the insulating film MZ1, the insulating film MZ2, and the insulating film MZ3 is formed on the silicon layer S in the formation region of the memory transistor MT in the memory region 11A. The insulating film GF2 is formed on the silicon layer S in the formation region of the selection transistor in the memory region 11A, and the insulating film GF2 is formed on the silicon layer S in the low-withstand-voltage MISFET formation region 11B.

In the structure of FIG. 59, the insulating film MZ comprising the stacked film of the insulating film MZ1, the insulating film MZ2, and the insulating film MZ3 is formed on the support substrate SS (p-type well PW1) in the formation region of the memory transistor MT in the memory region 1A. The insulating film GF1 is formed on the support substrate SS (p-type well PW1) in the formation region of the selection transistor in the memory region 1A, and the insulating film GF1 is formed on the support substrate SS (p-type well PW3) in the high-withstand-voltage MISFET formation region 1C.

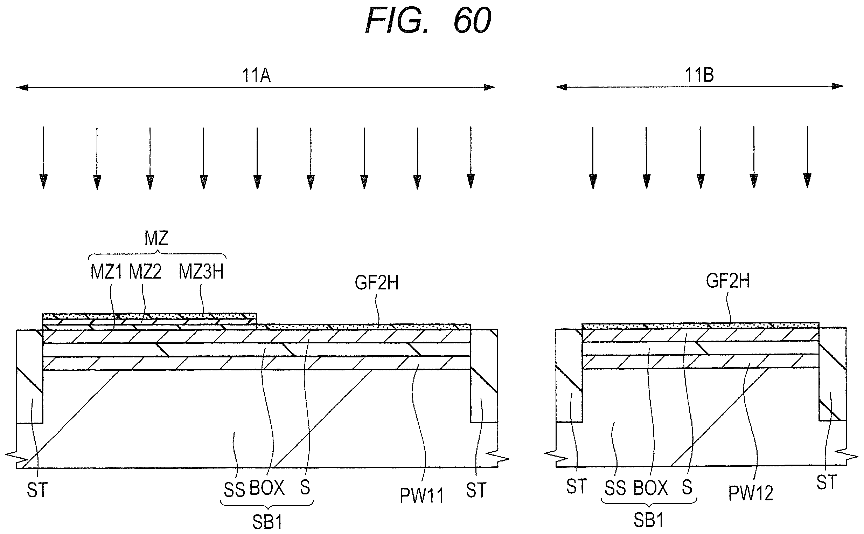

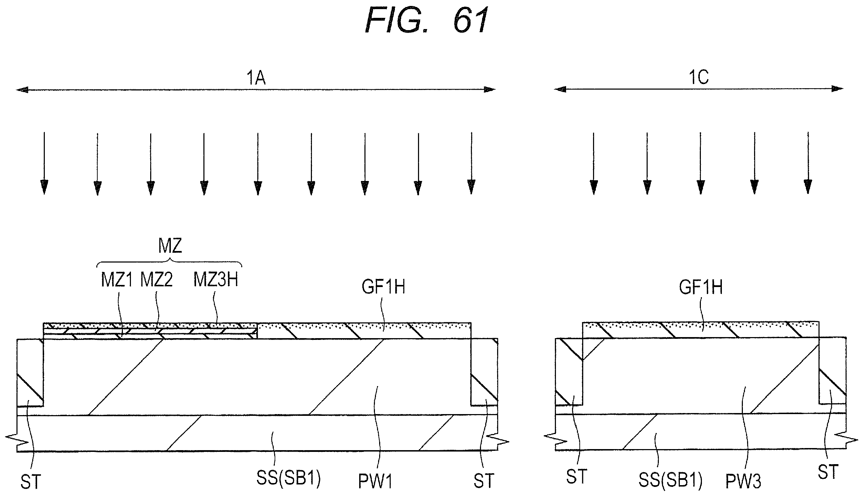

Subsequently, as shown in FIGS. 60 and 61, addition (deposition processing) of a metal or a metal oxide is performed. That is, as described in detail in the first embodiment, a minute amount of metal atoms or metal oxide molecules are deposited on the respective insulating films (insulating films MZ3, GF2, and GF1). For example, the metal or the metal oxide is deposited on the silicon oxide film using a sputtering process.

For example, Hf is deposited 1.0 × 10¹⁴ atoms/cm² at a low output of 27 W by a sputtering process using Hf as a target, and then Al is deposited 3.0 × 10¹³ atoms/cm² at a low output of 100 W by a sputtering process using Al as a target. Such metal atoms (Hf, Al) may be converted into metal oxides (HfO₂, Al₂O₃). The sputtering may be performed using a metal oxide target.

As a result, the insulating films (insulating films MZ3, GF2, and GF1) are converted into High-K added layers (insulating films MZ3H, GF2H, and GF1H). As described above, the metal or the metal oxide is added to the insulating films (insulating films MZ3, GF2, and GF1) configuring the gate insulating films of the respective cells, making it possible to improve the characteristics of the low-withstand-voltage MISFET2 and the high-withstand-voltage MISFET3. In the memory cell, a high saturation level of the threshold voltage can be maintained while the drive voltage (applied voltage for erase or write) is reduced, leading to improvement in reliability of the memory cell.

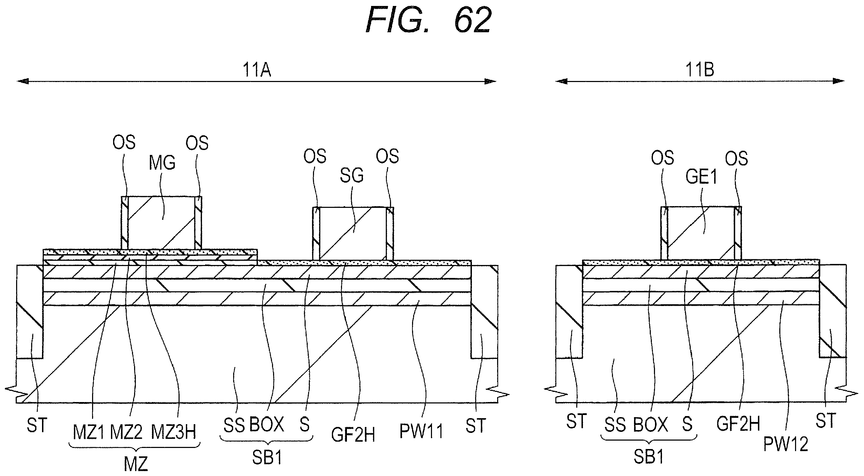

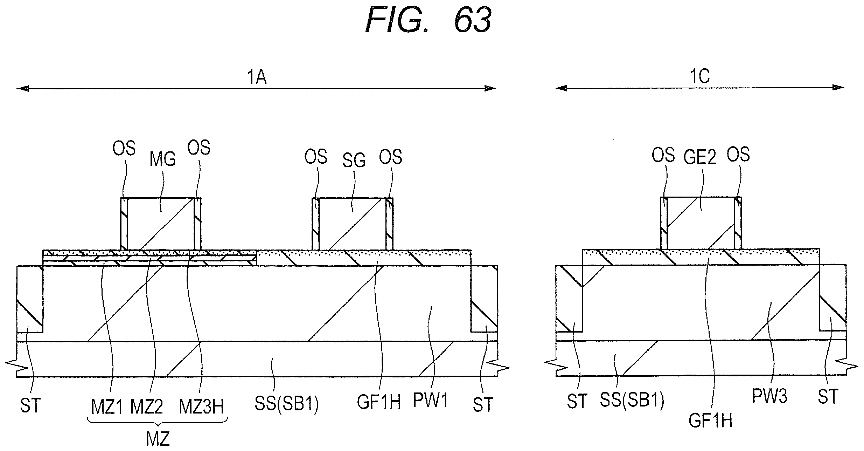

Subsequently, as shown in FIGS. 62 and 63, the silicon layer is patterned using a photolithography technique and an etching technique, thereby the gate electrodes MG, SG, GE1, and GE2 are formed, and the offset spacer (sidewall insulating film) OS is formed on each of the sidewalls of the gate electrodes MG, SG, GE1, and GE2. As described before, the selection gate electrode SG may be simply referred to as gate electrode.

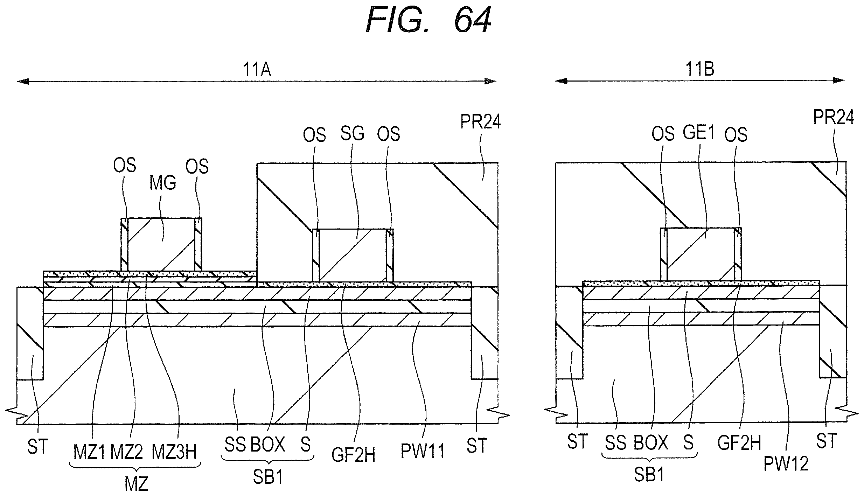

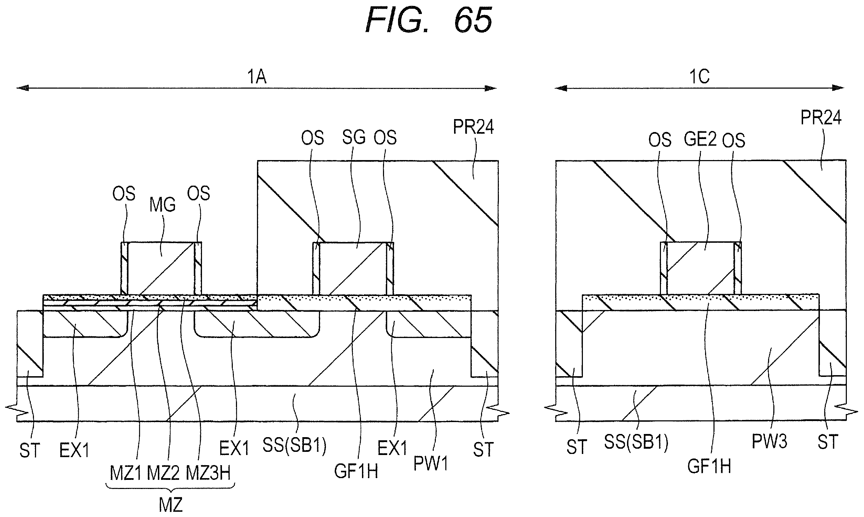

Subsequently, as shown in FIGS. 64 and 65, a photoresist film PR24 is formed so as to have openings in formation regions of the memory transistor MT in the memory regions 1A and 11A. The insulating films MZ2 and MZ3 are etched using the photoresist film PR24 as an etching mask. Subsequently, the photoresist film PR24 is removed. The n⁻-type semiconductor region EX1 may be formed in the semiconductor substrate SB (p-type well PW1) in the memory region 1A by an ion implantation process.

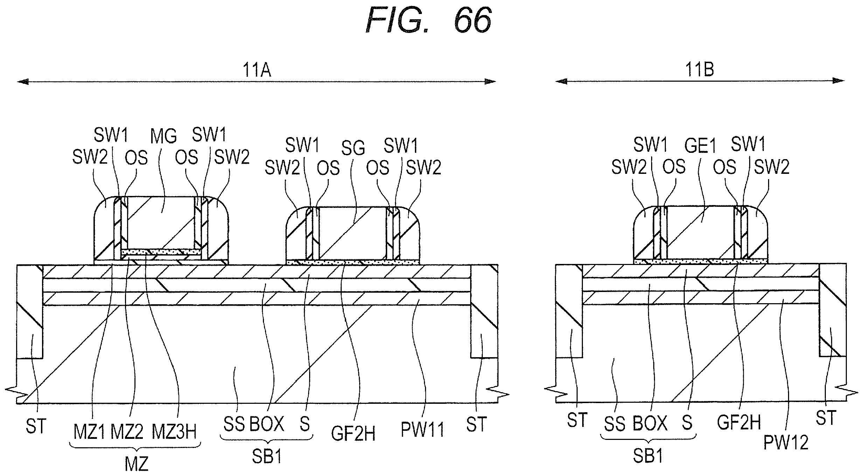

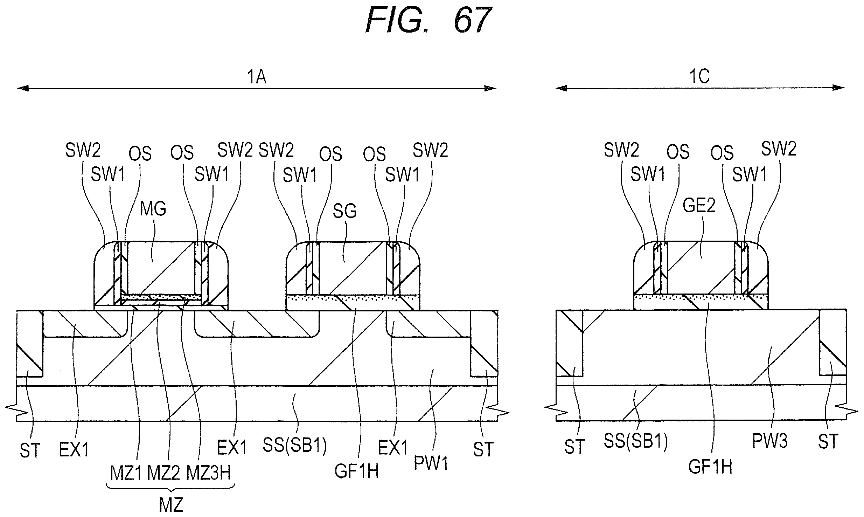

Subsequently, as shown in FIGS. 66 and 67, sidewall spacers SW1 and SW2 comprising different insulating films are formed as sidewall insulating films on the sidewall of each of the gate electrodes MG, SG, GE1, and GE2. For example, a silicon nitride film is formed using a CVD process or the like so as to cover the gate electrodes MG, SG, GE1, and GE2, and then the silicon nitride film is etched back by an anisotropic etching technique. As a result, the sidewall spacer SW1 is formed on the sidewall of each of the gate electrodes MG, SG, GE1, and GE2. Subsequently, for example, a silicon oxide film is formed using a CVD process or the like so as to cover the gate electrodes MG, SG, GE1, and GE2, and then the silicon oxide film is etched back by an anisotropic etching technique. As a result, the sidewall spacer SW2 is formed on the sidewall of each of the gate electrodes MG, SG, GE1, and GE2 with the sidewall spacer SW1 in between. At this time, the insulating films (insulating films MZ3H, GF2H, and GF1H) in portions, which are not covered with the gate electrodes MG, SG, GE1, and GE2 and the sidewall spacers SW1 and SW2, are also removed.

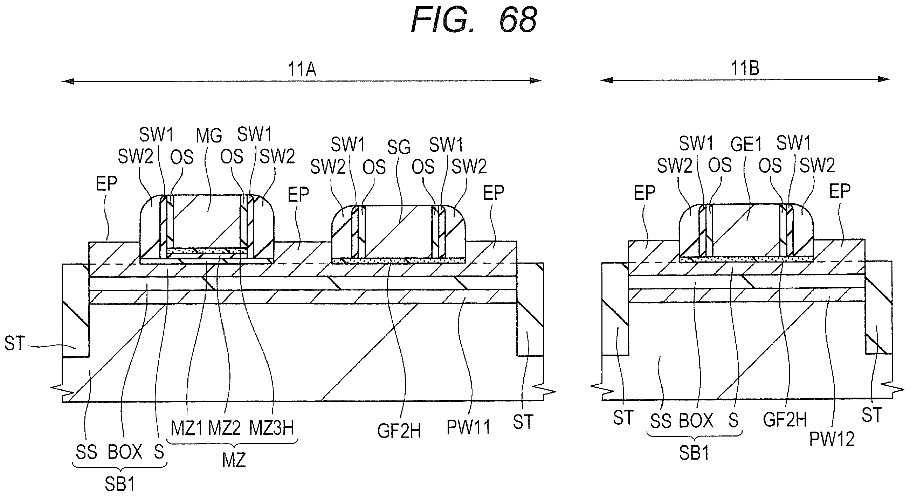

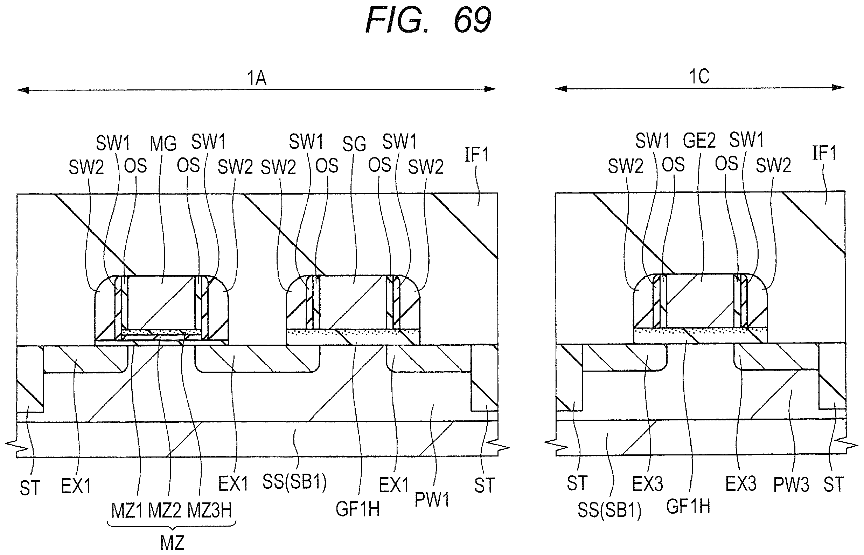

Subsequently, as shown in FIGS. 68 and 69, a protection insulating film (for example, a silicon nitride film) covering the memory region 1A and the high-withstand-voltage MISFET formation region 1C of the bulk region is formed, and the epitaxial layer EP is formed using an epitaxial growth process (also referred to as crystal growth process) on an exposed silicon layer S in the memory region 11A and the low-withstand-voltage MISFET formation region 11B of the SOI region.

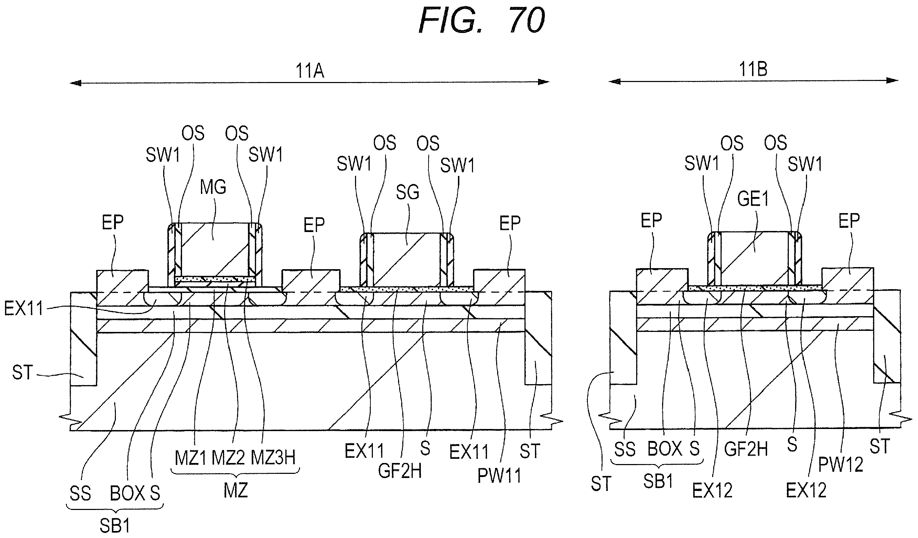

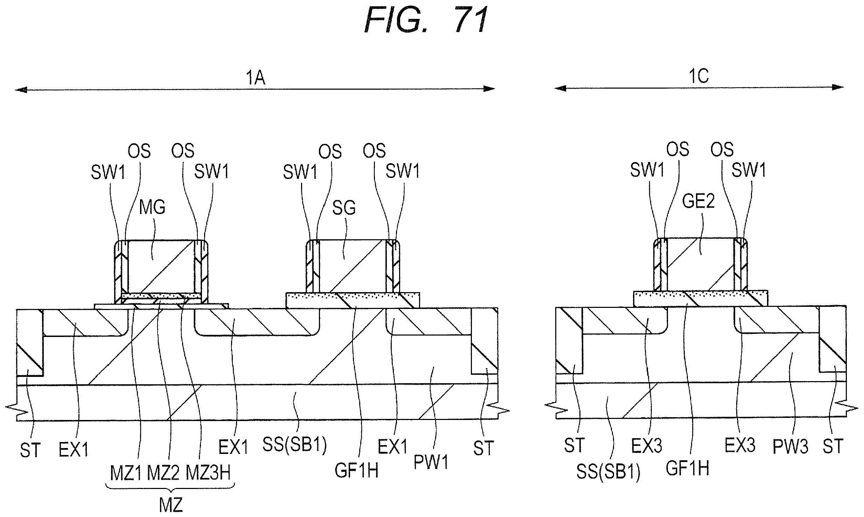

Subsequently, as shown in FIGS. 70 and 71, the sidewall spacer SW2 is removed, and an n-type impurity such as phosphorous (P) or arsenic (As) is ion-implanted into the regions of the silicon layer S on both sides of each of the gate electrodes MG, SG, and GE1 to form the n⁻-type semiconductor regions EX11 and EX12. The n-type impurity such as phosphorous (P) or arsenic (As) is also ion-implanted into the semiconductor substrate SB (p-type well PW1) on both sides of the gate electrode GE2 to form the n⁻-type semiconductor region EX3. The n⁻-type semiconductor regions EX11, EX12, and EX3 may be formed in individual ion implantation steps, or any combination of the n⁻-type semiconductor regions may be formed in the same ion implantation step.

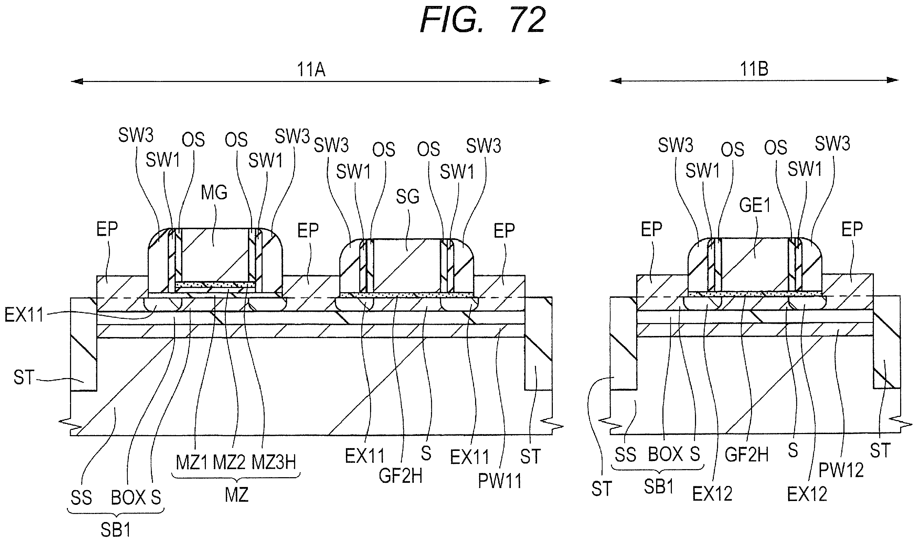

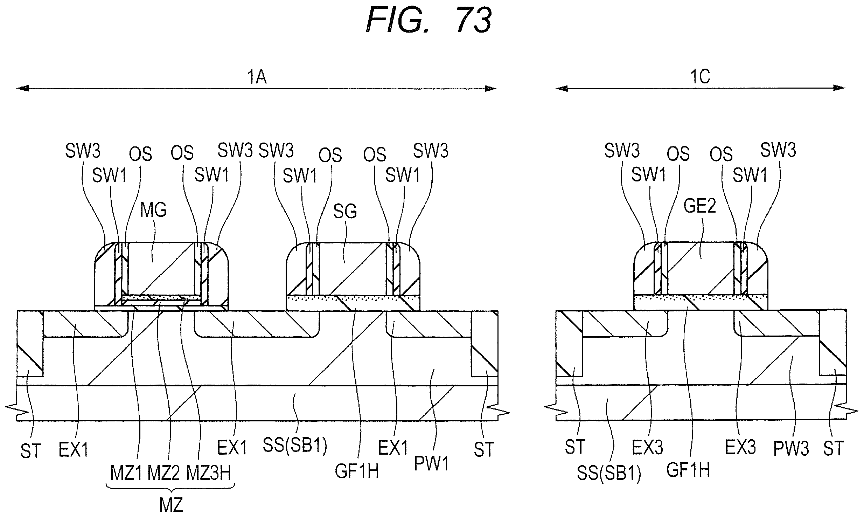

Subsequently, as shown in FIGS. 72 and 73, a sidewall spacer SW3 is formed. For example, a silicon oxide film is formed using a CVD process or the like so as to cover the gate electrodes MG, SG, GE1, and GE2, and then the silicon oxide film is etched back by an anisotropic etching technique. As a result, the sidewall spacer SW3 is formed on the sidewall of each of the gate electrodes MG, SG, GE1, and GE2 with the sidewall spacer SW1 in between.

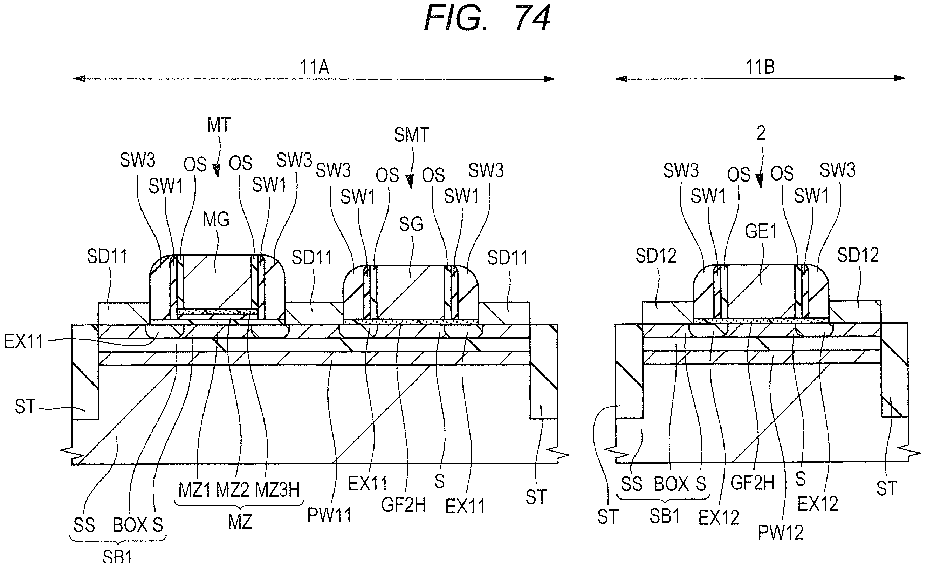

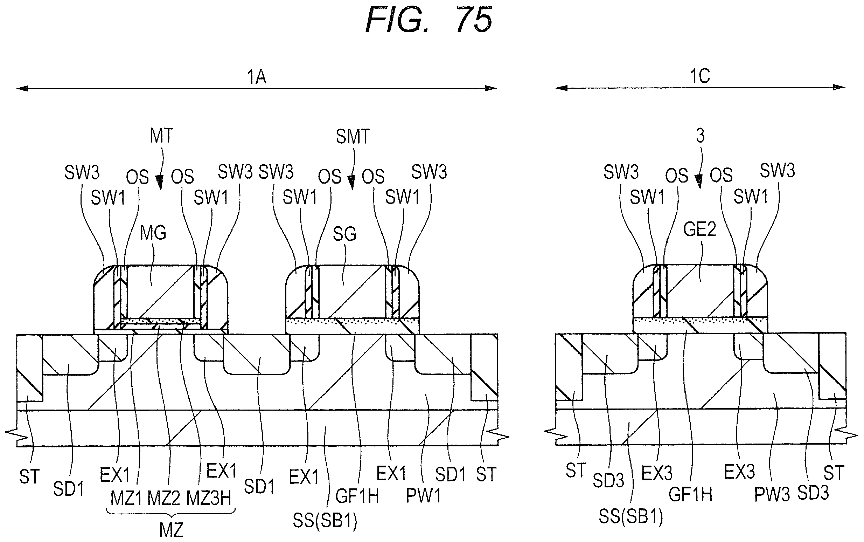

Subsequently, as shown in FIGS. 74 and 75, an n-type impurity such as phosphorous (P) or arsenic (As) is ion-implanted to form the n⁺-type semiconductor regions SD1, SD3, SD11, and SD12. The n⁺-type semiconductor regions SD1, SD3, SD11, and SD12 may be formed in individual ion implantation steps, or any combination of the n⁺-type semiconductor regions may be formed in the same ion implantation step.

In this way, the memory transistor MT and the selection transistor SMT are formed in each of the memory regions 1A and 11A, a low-withstand-voltage MISFET2 is formed in the low-withstand-voltage MISFET2 formation region 11B, and a high-withstand-voltage MISFET3 is formed in the high-withstand-voltage MISFET formation region 1C.

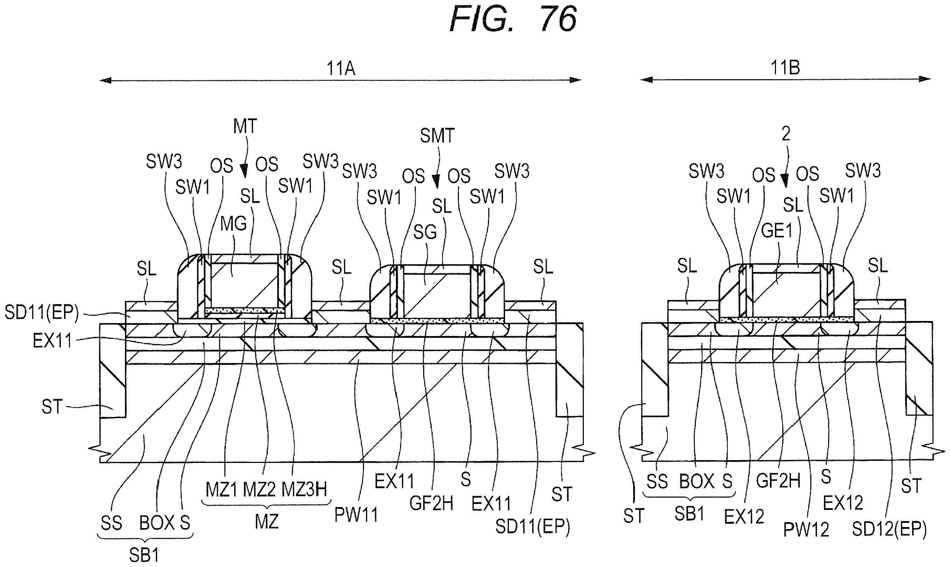

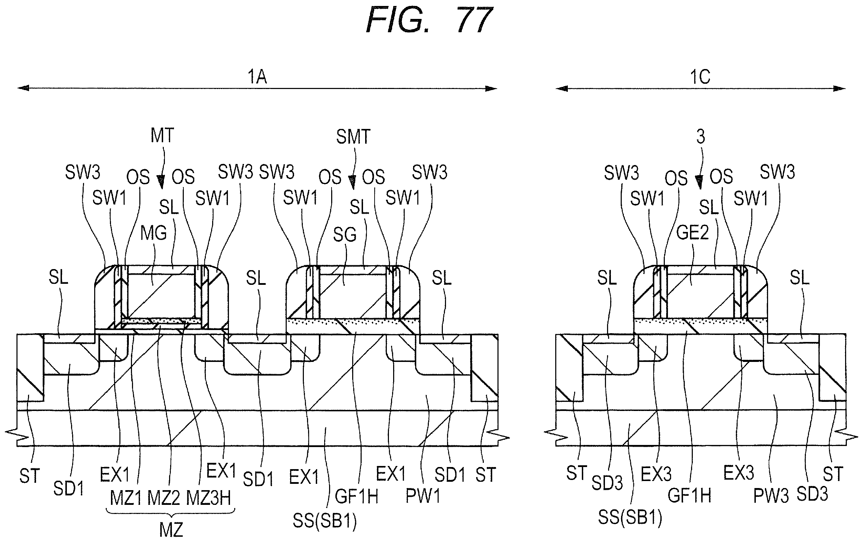

Subsequently, as shown in FIGS. 76 and 77, a metal silicide layer SL is formed by a salicide process. The metal silicide layer SL is formed over each of the n⁺-type semiconductor regions SD1, SD3, SD11, and SD12 and over each of the gate electrodes MG, SG, GE1, and GE2.

Subsequently, as shown in FIGS. 78 and 79, an insulating film IL1 is formed as an interlayer insulating film so as to cover the gate electrodes MG, SG, GE1, and GE2 and the sidewall spacers SW1 and SW3. Subsequently, the insulating film IL1 is dry-etched to form contact holes, and a conductive plug PG is formed in each contact hole. Subsequently, an insulating film IL2 is formed over the insulating film IL1 with the embedded plugs PG, and then an interconnection M1 is formed in the insulating film IL2. After that, interconnections of second and subsequent layers may be formed.

In this way, the semiconductor device of the third embodiment is manufactured.

Although the invention achieved by the inventors has been described in detail according to some embodiments thereof hereinbefore, the invention should not be limited thereto, and it will be appreciated that various modifications or alterations thereof may be made within the scope without departing from the gist of the invention.

For example, although an n-channel-type cell is exemplarily formed as the memory cell or MISFET in the above-described respective embodiments, a p-channel-type cell may also be formed. The n-channel-type cell and the p-channel-type cell may be formed together.

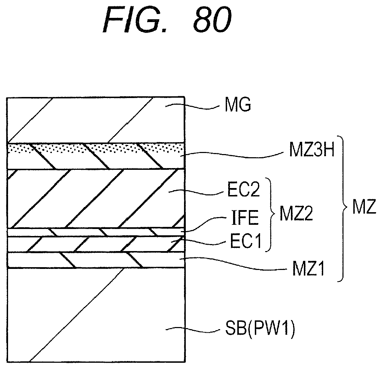

Although the insulating film MZ has been configured of the three-layered films (insulating films MZ1, MZ2, and MZ3), one of such component films may be a multilayer film. For example, as shown in FIG. 80, the insulating film MZ may be configured to comprise the insulating film MZ1, a charge storage film EC1, an insulating film IFE, a charge storage film EC2, and an insulating film MZ3H. The charge storage film EC1, the insulating film IFE, and the charge storage film EC2 configure the insulating film (charge storage part) MZ2. FIG. 80 is a sectional view illustrating another configuration of the insulating film MZ. For example, the insulating film MZ1 comprises a silicon oxide film, the insulating film MZ3H is a High-K added layer comprising a silicon oxide film and a metal or a metal oxide on the silicon oxide film, the insulating film IFE comprises a silicon oxynitride film, and the charge storage films EC1 and EC2 each comprise a silicon nitride film. That is, in this case, the insulating film MZ is configured of the silicon oxide film, the silicon nitride film, the silicon oxynitride film, the silicon nitride film, and the High-K added layer stacked in this order.

Such an insulating film MZ may be formed by the following steps, for example.

The insulating film MZ1 contains silicon and oxygen, and comprises, for example, silicon oxide. Preferably, the insulating film MZ1 can be formed by an in-situ steam generation (ISSG) oxidation process. In the ISSG oxidation process, hydrogen and oxygen are directly introduced into a decompressed heat treatment chamber to cause a radical oxidation reaction on a surface of a semiconductor substrate comprising silicon or the like heated to a temperature of, for example, 800 to 1100°C, thereby an oxide film comprising, for example, silicon oxide is formed on the surface of the semiconductor substrate SB. Since the radical oxidation reaction is used in the ISSG oxidation process, oxidation power in the ISSG oxidation process is higher than oxidation power in the thermal oxidation process, for example. Using the ISSG oxidation process therefore makes it possible to form the insulating film MZ1 comprising silicon oxide having a compact and good film quality. The insulating film MZ1 has a thickness of about 2 nm, for example.

Subsequently, the charge storage film EC1 is formed. The charge storage film EC1 is an insulating film containing silicon and nitrogen, and comprises, for example, silicon nitride. The charge storage film EC1 is formed by, for example, a chemical vapor deposition (CVD) process, and is preferably formed by a low pressure chemical vapor deposition (LPCVD) process using dichlorosilane (SiH₂Cl₂) gas and ammonia (NH₃) gas as source gases, for example. Alternatively, the charge storage film EC1 is formed by an LPCVD process using silane (SiH₄) gas and ammonia gas as source gases, for example. The charge storage film EC1 has a thickness of about 2 nm, for example.

Preferably, the charge storage film EC1 is formed by, for example, an atomic layer deposition (ALD) process. In the ALD process, for example, a step of forming one atomic layer through chemical adsorption of precursor gas molecules and a step of purging and removing the surplus precursor gas molecules are alternately repeated, thereby atomic layers are stacked one by one and thus the film is formed. In the LPCVD process, a temperature of 600°C or higher is typically required to form a homogenous charge storage film EC1 comprising, for example, silicon nitride. In the ALD process, however, a homogenous charge storage film EC1 can be formed at a low temperature of less than 600°C, for example, about 400°C.

The charge storage film EC1 formed by the ALD process and comprising, for example, silicon nitride can be adjusted such that silicon is not strongly bonded with nitrogen by controlling a process condition, for example. In such a case, an insulating film IFE comprising, for example, silicon oxide or silicon oxynitride can be easily formed on the top of the charge storage film EC1 by liquid treatment using a treatment liquid containing water, i.e., by wet processing.

In place of the ALD process, for example, a plasma-enhanced chemical vapor deposition process may be used to form the charge storage film EC1 comprising, for example, silicon nitride at a low temperature of less than 600°C, which is a deposition temperature of the LPCVD process or the thermal CVD process, for example, at about 400°C.

Subsequently, the insulating film IFE is formed by liquid treatment using a treatment liquid containing water, i.e., by wet processing. In this step, the insulating film IFE is formed on the charge storage film EC1. The insulating film IFE contains silicon and oxygen, and comprises, for example, silicon oxynitride. The insulating film IFE may comprise silicon oxide. For example, pure water is supplied as the treatment liquid to the top of a substrate for about 30 sec, for example. The top of the charge storage film EC1 comprising, for example, silicon nitride is subjected to the liquid treatment, i.e., the wet processing, using the supplied treatment liquid, thereby the insulating film IFE having a predetermined thickness is formed on the charge storage film EC1. The thickness of the insulating film IFE formed by such liquid treatment is at least one atomic layer, or more than 0.1 nm. In addition, the thickness of the insulating film IFE is smaller than the thickness of the charge storage film EC1. As a result, electrons or holes can be easily injected from the semiconductor substrate SB into the charge storage film EC2, and the injected electrons or holes can be prevented from escaping from the charge storage film EC2 into the semiconductor substrate SB. The thickness of the insulating film IFE is smaller than the thickness of the insulating film MZ1. As a result, the thickness of the insulating film MZ1 as a bottom oxide film can be maintained.

Subsequently, the charge storage film EC2 is formed on the insulating film IFE. The charge storage film EC2 is an insulating film containing silicon and nitrogen, and comprises, for example, silicon nitride. The charge storage film EC2 is formed by, for example, a CVD process, and is preferably formed by an LPCVD process using dichlorosilane (SiH₂Cl₂) gas and ammonia (NH₃) gas as source gases, for example. Alternatively, the charge storage film EC2 is formed by an LPCVD process using silane (SiH₄) gas and ammonia gas as source gases, for example. The charge storage film EC2 has a thickness of about 9 nm, for example.

Subsequently, the insulating film MZ3 is formed on the charge storage film EC2. The insulating film MZ3 contains silicon and oxygen, and comprises, for example, silicon oxide. Preferably, the insulating film MZ2 is formed by a thermal oxidation process such as a wet oxidation process, or an ISSG oxidation process. In the wet oxidation process, heat treatment is performed in a gas atmosphere comprising oxygen gas mixed with deionized vapor. Alternatively, the insulating film MZ2 is preferably formed by a high temperature oxide (HTO) process. This makes it possible to form the insulating film MZ2 comprising silicon oxide having a compact and good film quality. The insulating film MZ2 has a thickness of about 3 nm, for example. Subsequently, addition of a metal or a metal oxide is performed to form the insulating film MZ3H.

In this way, the insulating film MZ comprising the insulating film MZ1, the charge storage film EC1, the insulating film IFE, the charge storage film EC2, and the insulating film MZ3 is formed on the top of the substrate. In addition, the insulating film MZ2 is formed by the charge storage film EC1, the insulating film IFE, and the charge storage film EC2.

## Claims

1. A semiconductor device, comprising:
a semiconductor substrate; and
a nonvolatile memory cell disposed in a first region of the semiconductor substrate,
wherein the nonvolatile memory cell comprises:
a first gate electrode disposed over the semiconductor substrate; and
a first insulating film that is formed between the first gate electrode and the semiconductor substrate, and internally has a charge storage part,
wherein the first insulating film comprises:
a first film comprising a silicon oxide film formed over the semiconductor substrate;
a second film that comprises a silicon nitride film formed over the first film and serves as the charge storage part; and
a third film that is formed over the second film and comprises a silicon oxide film,
wherein the third film comprises the silicon oxide film and one of a metal and a metal oxide added in atomic or molecular state onto the silicon oxide film,
wherein oxide of the metal has a dielectric constant higher than a dielectric constant of silicon oxide, and
wherein the metal oxide has a dielectric constant higher than the dielectric constant of silicon oxide.

2. The semiconductor device according to claim 1, wherein one of the metal and the metal oxide is added at a surface density of 1 × 10¹³ atoms/cm² to 5 × 10¹⁴ atoms/cm² on the silicon oxide film.

3. The semiconductor device according to claim 1, wherein the metal comprises one of Hf and Al, and the metal oxide comprises one of HfO₂ and Al₂O₃.

4. The semiconductor device according to claim 1, wherein the third film is a layer to which Hf, Al, HfO₂ and Al₂O₃ are added.

5. The semiconductor device according to claim 4, wherein the second film comprises a silicon oxynitride film in the silicon nitride film.

6. The semiconductor device according to claim 5, further comprising a selection transistor formed in the first region,
wherein the selection transistor comprises:
a selection gate electrode disposed alongside the first gate electrode over the semiconductor substrate; and
a selection gate insulating film formed between the selection gate electrode and the semiconductor substrate, and
wherein the selection gate insulating film is a layer to which one of the metal and the metal oxide is added.

7. The semiconductor device according to claim 5, further comprising a first transistor disposed in the second region of the semiconductor substrate,
wherein the first transistor comprises:
a second gate electrode disposed over the semiconductor substrate; and
a second gate insulating film formed between the second gate electrode and the semiconductor substrate,
wherein the second gate insulating film is a layer to which one of the metal and the metal oxide is added.

8. The semiconductor device according to claim 7, further comprising:
a second transistor disposed in the third region of the semiconductor substrate,
wherein the second transistor comprises:
a third gate electrode disposed over the semiconductor substrate; and
a third gate insulating film formed between the third gate electrode and the semiconductor substrate,
wherein the third gate insulating film is thicker than the second gate insulating film, and is a layer to which one of the metal and the metal oxide is added.

9. The semiconductor device according to claim 8,
wherein the semiconductor substrate comprises a support substrate, an insulating layer disposed over the support substrate, and a semiconductor layer disposed over the insulating layer,
wherein the nonvolatile memory cell disposed in the first region is formed in the semiconductor layer,
wherein the first transistor disposed in the second region is formed in the support substrate in the second region from which the semiconductor layer and the insulating layer are removed, and
wherein the second transistor disposed in the third region is formed in the support substrate in the third region from which the semiconductor layer and the insulating layer are removed.

10. The semiconductor device according to claim 9, further comprising a selection transistor formed in the first region,
wherein the selection transistor is formed in the support substrate, and comprises:
a selection gate electrode disposed alongside the first gate electrode over the support substrate; and
a selection gate insulating film formed between the selection gate electrode and the support substrate, and
wherein the selection gate insulating film is a layer to which one of the metal and the metal oxide is added.

11. A method of manufacturing a semiconductor device, the method comprising the steps of:
(a) providing a semiconductor substrate comprising a first region to form a nonvolatile memory cell;
(b) forming a first insulating film for a gate insulating film of the memory cell over the semiconductor substrate; and
(c) forming a conductive film over the first insulating film, and patterning the conductive film to form a first gate electrode for the memory cell,
wherein the step (b) comprises the steps of:
(b1) forming a first film comprising a first silicon oxide film over the semiconductor substrate;
(b2) forming a second film over the first film, the second film comprising a silicon nitride film and serving as a charge storage part; and
(b3) forming a third film over the second film, the third film comprising a second silicon oxide film and being a layer to which one of a metal and a metal oxide is added,
wherein the step (b3) comprises the steps of:
(b3-1) forming the second silicon oxide film over the second film; and
(b3-2) adding one of the metal and the metal oxide onto the second silicon oxide film in an atomic or molecular state by a sputtering process,
wherein oxide of the metal has a dielectric constant higher than a dielectric constant of silicon oxide, and
wherein the metal oxide has a dielectric constant higher than the dielectric constant of silicon oxide.

12. The method according to claim 11, wherein the metal is one of Hf and Al, and the metal oxide is one of HfO₂ and Al₂O₃.

13. The method according to claim 11, wherein the third film is a layer to which Hf, Al, HfO₂ and Al₂O₃ are added, and
wherein the step (b3-2) comprises the steps of:
adding Hf onto the second silicon oxide film by a sputtering process using a Hf target, and
adding Al onto the second silicon oxide film by a sputtering process using an Al target.

14. The method according to claim 13, wherein the step (b2) comprises the steps of:
(b2-1) forming a first silicon nitride film over the first film;
(b2-2) oxidizing an upper part of the first silicon nitride film to form a silicon oxynitride film; and
(b2-3) forming a second silicon nitride film over the silicon oxynitride film.

15. A method of manufacturing a semiconductor device, the method comprising the steps of:
(a) providing a semiconductor substrate comprising a first region to form a nonvolatile memory cell, a second region to form a first transistor, and a third region to form a second transistor;
(b) forming a first insulating film for a gate insulating film of the first transistor over the semiconductor substrate in each of the first, second, and third regions;
(c) after the step (b), removing the first insulating film in the first region to leave the first insulating film in each of the second and third regions;
(d) after the step (c), forming a second insulating film for a gate insulating film of the memory cell over the semiconductor substrate in the first region;
(e) after the step (d), removing the first insulating film in the third region to leave the first insulating film in the second region and the second insulating film in the first region;
(f) after the step (e), forming a third insulating film for a gate insulating film of the second transistor over the semiconductor substrate in the third region;
(g) adding one of a metal and a metal oxide in an atomic or molecular state by a sputtering process onto the first, second, and third insulating films; and
(h) after the step (g), forming a first film over first, second, and third insulating films, and patterning the first film to form a first gate electrode for the memory cell, a second gate electrode for the first transistor, and a third gate electrode for the second transistor,
wherein oxide of the metal has a dielectric constant higher than a dielectric constant of silicon oxide, and
wherein the metal oxide has a dielectric constant higher than the dielectric constant of silicon oxide.

16. The method according to claim 15, wherein the second insulating film comprises a first silicon oxide film, a silicon nitride film over the first silicon oxide film, a second silicon oxide film over the silicon nitride film.

17. The method according to claim 16, wherein the metal is one of Hf and Al, and the metal oxide is one of HfO₂ and Al₂O₃.

18. The method according to claim 16, wherein the second silicon oxide film is a layer to which Hf, Al, Hf0₂, and Al₂O₃ are added, and
wherein the step (b3-2) comprises the steps of:
adding Hf onto the second silicon oxide film by a sputtering process using a Hf target; and
adding Al onto the second silicon oxide film by a sputtering process using an Al target.
